(19) Europäisches Patentamt / European Patent Office / Office européen des brevets

(11) **EP 2 897 293 A1**

(12) **EUROPÄISCHE PATENTANMELDUNG**

(43) Veröffentlichungstag:
**22.07.2015 Patentblatt 2015/30**

(51) Int Cl.:
*H03M 1/10* (2006.01)  *H03M 1/06* (2006.01)
*H03M 1/46* (2006.01)  *H03M 1/68* (2006.01)

(21) Anmeldenummer: **15151291.0**

(22) Anmeldetag: **15.01.2015**

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**
Benannte Erstreckungsstaaten:
**BA ME**

(30) Priorität: **15.01.2014 DE 102014200624**

(71) Anmelder: **Fraunhofer-Gesellschaft zur Förderung der angewandten Forschung e.V. 80686 München (DE)**

(72) Erfinder:
• **Völker, Matthias 90768 Fürth (DE)**
• **Neubauer, Harald 91052 Erlangen (DE)**

(74) Vertreter: **Zimmermann, Tankred Klaus et al Schoppe, Zimmermann, Stöckeler Zinkler, Schenk & Partner mbB Patentanwälte Radlkoferstrasse 2 81373 München (DE)**

(54) **Digital-analog-wandler, analog-digital-wandler und verfahren zur kalibrierung eines digital-analog-wandlers**

(57)  Ein Digital-Analog-Wandler umfasst ein MSB-Feld, ein LSB-Feld, ein Koppelelement und eine Kalibriereinheit. Das MSB-Feld weist eine Mehrzahl elektrischer Bauelemente, die einen gemeinsamen MSB-Summenpunkt bilden, und jeweils selektiv entsprechend einer MSB-Kombination mittels eines elektrischen Schaltelements beaufschlagbar sind, auf. Die Mehrzahl der elektrischen Bauelemente weisen unterschiedliche Leitwerte x auf, die entsprechend einem Ausschnitt einer mathematischen Folge mit $x_n = f(x_{n-1})$ in Relation zueinander stehen oder um jeweilige Toleranzwerte von der mathematischen Folge abweichen. Das LSB-Feld weist eine zweite Mehrzahl der elektrischen Bauelemente, die einen gemeinsamen LSB-Summenpunkt bilden und jeweils entsprechend einer LSB-Kombination mittels des elektrischen Schaltsignals beaufschlagbar sind, auf. Das Koppelelement koppelt den LSB-Summenpunkt und den MSB-Summenpunkt miteinander. Durch die elektrischen Bauelemente des MSB-Feldes und des LSB-Feldes wird ein elektrisches Signal an dem Summenpunkt erzeugt, wobei das elektrische Signal, z.B. ein Spannungssignal, von der MSB-Kombination und der LSB-Kombination abhängig ist. Die Kalibriereinheit ist ausgebildet, um die jeweiligen Toleranzwerte für die elektrischen Bauelemente des MSB-Feldes zu ermitteln. Hierzu wird unter Berücksichtigung einer ersten LSB-Kombination ein sich infolge der ersten MSB-Kombination einstellendes erstes elektrisches Signal an dem Summenpunkt ermittelt. In einem nächsten Schritt wird die erste MSB-Kombination variiert, um eine zweite MSB-Kombination zu erhalten. Hierbei kann die MSB-Kombination beispielsweise um eine toleranzbehaftete niedrigste Bitwertigkeit für das MSB-Feld variiert werden. Ausgehend von dieser zweiten MSB-Kombination wird eine zweite LSB-Kombination ermittelt, die an dem Summenpunkt zu einem elektrischen Signal führt, wobei das zweite elektrische Signal vergleichbar mit dem ersten elektrischen Signal ist, also in einem Toleranzbereich dem ersten elektrischen Signal gleicht. Ausgehend von dieser zweiten LSB-Kombination zusammen mit der ersten LSB-Kombination, d.h. beispielsweise ausgehend von einer Differenz zwischen der ersten und der zweiten LSB-Kombination kann eine Auskunft über einen ersten Toleranzwert für ein elektrisches Bauelement des MSB-Feldes oder Auskunft über einen weiteren Toleranzwert für eine Gruppe von elektrischen Bauelementen des MSB-Feldes gegeben werden.

FIGUR 1

**Beschreibung**

Ausführungsbeispiele der vorliegenden Erfindung beziehen sich auf einen Digital-Analog-Wandler, einen Analog-Digital-Wandler mit einem Digital-Analog-Wandler und auf ein Kalibrierungsverfahren zur Kalibrierung eines Digital-Analog-Wandlers.

Analog-Digital-Wandler dienen dazu, ein analoges Eingangssignal (im Folgenden als Messsignal bezeichnet) in digitale Daten, z.B. in einen Bitstream, zu wandeln. Hierbei wird das Messsignal zeitlich quantisiert, um dieses so in einzelne Samples zu untergliedern und die einzelnen Samples in Bezug auf ihren Wert abzutasten, dass dem analogen Wert in dem Sample ein digitaler Wert, z.B. ein Binärwert mit einer Auflösung (angegeben in Bit) zugeordnet werden kann. Die zeitliche Quantisierung kann beispielsweise durch eine Abtast-Halte-Schaltung (englisch: Sample-and-Hold-Schaltung) realisiert werden, wobei es für die wertmäßige Quantisierung unterschiedliche Ansätze gibt.

Ein weit verbreiteter Ansatz ist die sogenannte sukzessive Approximation. Sukzessive-Approximations-Analog-Digital-Umsetzer (SAR ADUs) arbeiten nach dem Prinzip der Intervallverschachtelung. Hierbei wird ein Messsignal mit einem durch einen Digital-Analog-Wandler (DAC) erzeugten Referenzwert verglichen. In Abhängigkeit, ob der Referenzwert größer oder kleiner als der Wert des Messsignals ist, wird ein neuer Referenzwert erzeugt und das Verfahren entsprechend wiederholt. Typischerweise wird das Verfahren so lange iteriert, bis eine Änderung des Referenzwertes zu einer nicht mehr auflösbaren Änderung bei der Komparation führt und/oder der DA-Wandler seine feinste Stufe erreicht hat. Hierbei ist es vorteilhaft, wenn bei der Erzeugung des Referenzsignals die Änderungsschritte mit zunehmender Iteration abnehmen. Durch die kleinste Änderungsstufe, die durch die niedrigste Bitwertigkeit (englisch: Least Significant Bit, LSB) repräsentiert ist, wird die Auflösungsfähigkeit bei der Abtastung definiert; hierbei ist allerdings auch der Dynamikumfang zu beachten, der als Quotient aus dem größten und dem kleinsten darstellbaren Wert gebildet ist. Die Genauigkeit und Linearität des Umsetzungsverfahrens bei der Analog-Digital-Wandlung hängen sehr stark von der Linearität des verwendeten Digital-Analog-Wandlers ab. Insofern wird durch die Erhöhung der Präzession bei der DA-Wandlung die Präzession bei der AD-Wandlung verbessert.

Bei den sukzessiven Approximations-Analog-Digital-Wandlern kommen häufig geschaltete Kapazitäten oder andere geschaltete elektrische Bauelemente als Digital-Analog-Wandler zum Einsatz. Schwankungen im Fertigungsprozess von elektrischen Bauelementen führen dazu, dass die verschiedenen Leitwerte (z.B. Kapazitäten) nicht exakt im entworfenen Verhältnis zueinander stehen. Diese Abweichung wird Mismatch genannt und begrenzt die Genauigkeit des Digital-Analog-Wandlers bzw. damit die Genauigkeit des SAR-Analog-Digital-Wandlers.

Entsprechend dem Stand der Technik gibt es einige Ansätze, dieses Mismatch zu berücksichtigen: Entsprechend einer ersten Variante können die Grundkapazitäten, die für den Digital-Analog-Wandler verwendet werden, so groß gewählt werden, dass die Fertigungsschwankungen keinen Einfluss haben. Hintergrund hierzu ist, dass die relativen Schwankungen bei den meisten integrierten Bauelementen mit der Wurzel der Fläche abnehmen. Dies führt zu einem erhöhten Flächenbedarf und damit auch zu erhöhtem Stromverbrauch des Gesamtsystems. Entsprechend einer zweiten Variante kann eine analoge Kalibrierung durchgeführt werden. Hierbei wird ein zusätzlicher Kalibrier-DAC verwendet, der die Schwankungen des Haupt-DACs ausgleicht. Die benötigten Kalibrierwerte werden nach der Produktion mit einer exakten Signalquelle vermessen. Hierbei wird jedoch zusätzliche analoge Schaltungstechnik benötigt. Entsprechend einer dritten Variante kann mittels einer sogenannten digitalen Kalibrierung eine Korrektur des digitalen Ausgangswerts nachträglich erfolgen. Hierzu werden im Vorfeld die einzelnen Kapazitäten exakt vermessen, um so einen Korrekturwert abzuleiten. Die Ermittlung des Korrekturwerts ist beispielsweise durch Vermessung des Analog-Digital-Wandlers unter Zuhilfenahme einer exakten Signalquelle möglich. Des Weiteren wird in einer Veröffentlichung von Um et al. mit dem Titel "A Digital-Domain Calibration of Split-Capacitor DAC for a Differential SAR ADC without Additional Analogue Circuits" eine Selbstkalibrierung durch Umkonfiguration des Analog-Digital-Wandlers beschrieben. Eine derartige Selbstkalibrierung ist auch durch eine zusätzliche analoge Schaltung möglich, wie in der Patentschrift US 4970514 beschrieben ist. Somit lässt sich feststellen, dass die hier gezeigten Verfahren bzw. Schaltungen häufig die Nachteile analoger Schaltungstechnik mit sich bringen bzw. sehr exakte Korrekturwerte für die spezifische Schaltung ermittelt werden müssen. Deshalb besteht der Bedarf nach einem verbesserten Ansatz.

Aufgabe der vorliegenden Erfindung ist es, ein Konzept für einen Digital-Analog-Wandler, z.B. zum Einsatz in einem Analog-Digital-Wandler, mit Selbstkalibrierungsfähigkeiten zu schaffen, welcher sich insbesondere durch höhe Präzision und einfache Handhabung sowie universellen Einsatz auszeichnet.

Die Aufgabe wird durch die unabhängigen Patentansprüche gelöst.

Ausführungsbeispiele der vorliegenden Erfindung schaffen einen Digital-Analog-Wandler mit einem MSB-Feld, einem LSB-Feld, einem Koppelelement und einer Kalibriereinheit. Das MSB-Feld ("Most Significant Bit"-Feld), also das Feld, das das elektrische Schaltungselement, welches das Bit mit der höchsten Wertigkeit (englisch: Most Significant Bit, MSB) umfasst, enthält, weist eine Mehrzahl elektrischer Bauelemente, die einen gemeinsamen MSB-Summenpunkt bilden, und jeweils selektiv entsprechend einer MSB-Kombination mittels eines elektrischen Schaltelements beaufschlagbar sind, auf. Die Mehrzahl der elektrischen Bauelemente weisen unterschiedliche Leitwerte x auf, die entsprechend einem Ausschnitt einer mathematischen Folge mit $x_n = f(x_{n-1})$ in Relation zueinander stehen oder um jeweilige Toleranzwerte von der mathematischen Folge abweichen. Das LSB-Feld (Least Significant Bit-Feld), also das Feld, welches das elektrische Bauelement umfasst, das dem Bit der geringsten Wertigkeit (LSB) zugeordnet ist, weist eine zweite Mehrzahl der elektrischen Bauelemente, die einen gemeinsamen LSB-Summenpunkt bilden und jeweils entsprechend einer LSB-Kombination mittels des elektrischen Schaltsignals beaufschlagbar sind, auf. Das Koppelelement koppelt den LSB-Summenpunkt und den MSB-Summenpunkt miteinander. Durch die elektrischen Bauelemente des MSB-Feldes und des LSB-Feldes wird (bei Anlegen des elektrischen Schaltsignals) ein elektrisches Signal an dem Summenpunkt, welcher mit dem MSB-Summenpunkt und dem LSB-Summenpunkt gekoppelt ist bzw. der MSB-Summenpunkt sein kann, erzeugt, wobei das elektrische Signal, z.B. ein Spannungssignal, von der MSB-Kombination und der LSB-Kombination abhängig ist. Die Kalibriereinheit ist ausgebildet, um die jeweiligen Toleranzwerte für die elektrischen Bauelemente des MSB-Feldes zu ermitteln. Hierzu wird unter Zuhilfenahme bzw. oder Berücksichtigung einer ersten LSB-Kombination ein sich infolge der ersten MSB-Kombination einstellendes erstes elektrisches Signal an dem Summenpunkt ermittelt. In einem nächsten Schritt wird die erste MSB-Kombination variiert, um eine zweite MSB-Kombination zu erhalten. Hierbei kann die MSB-Kombination beispielsweise um eine toleranzbehaftete niedrigste Bitwertigkeit für das MSB-Feld (d.h. z.B. im einen Schritt) variiert werden, wobei toleranzbehaftet, z.B. +/- 15 %, +/- 5 % oder +/- 1 % heißt. Ausgehend von dieser zweiten MSB-Kombination wird eine zweite LSB-Kombination ermittelt, die an dem Summenpunkt zu einem elektrischen Signal (zusammen mit der zweiten MSB-Kombination) führt, wobei das zweite elektrische Signal vergleichbar mit dem ersten elektrischen Signal ist (bzw. das also zu demselben (analogen) elektrischen Signal führt oder, um exakt zu sein, in einem Toleranzbereich von beispielsweise +/- 15 % dem ersten elektrischen Signal gleicht). Ausgehend von dieser zweiten LSB-Kombination zusammen mit der ersten LSB-Kombination, d.h. beispielsweise ausgehend von einer Differenz zwischen der ersten und der zweiten LSB-Kombination kann eine Auskunft über einen ersten Toleranzwert für ein elektrisches Bauelement des MSB-Feldes (z.B. für das der niedrigsten Bitwertigkeit zugeordnete elektrische Bauelement) oder Auskunft über einen weiteren Toleranzwert für eine Gruppe von elektrischen Bauelementen des MSB-Feldes (die typischerweise zumindest das elektrische Bauelement zugeordnet zu der geringsten Bitwertigkeit und das elektrische Bauelement zugeordnet zu der nächst größeren Bitwertigkeit umfassen) gegeben werden.

Kern der vorliegenden Erfindung liegt somit darin, dass der Digital-Analog-Wandler mit einem MSB-Feld und einem LSB-Feld bzw. zumindest die Ergebnis-signifikanten Bauelemente, also die MSB-Bauelemente (Bauelemente mit der höheren Bitwertigkeit, MSB-Feld) des Digital-Analog-Wandlers, mittels eines speziellen Algorithmus unter Zuhilfenahme des LSB-Feldes vermessen werden können. Hierzu werden je zwei redundante Kombinationen (jeweils bestehend aus einer MSB-Kombination und ggf. einer LSB-Kombination) gesucht, die zu demselben, sich einstellenden analogen Ausgangssignal des DA-Wandlers führen. Eine erste der zwei redundante binäre Kombinationen kann ausgehend von einer vorgegebenen MSB-Kombination z.B. unter Nutzung eines typischen SAR-Algorithmus, also durch Variation der LSB-Kombination, ermittelt werden, während die zweite nach Variationen der MSB-Kombination, bevorzugt um einen niedrigen Wert (z.B. um eine niedrigste Bitwertigkeit des MSB-Feldes) ebenso unter Variation der LSB-Kombination (mit dem SAR-Algorithmus) ermittelt wird. Für die zweite gewählte MSB-Kombination wird eine solche gewählt, von der typischerweise bekannt ist, dass es für diese eine redundante Kombination, also insbesondere eine passende LSB-Kombination, geben kann. Diese Voraussetzung ist typischerweise dann erfüllt, wenn die Änderung im MSB-Feld bezogen auf den absoluten Wert nicht allzu groß ist oder konkret den Einfluss des LSB-Feldes auf das sich einstellenden elektrische Signal am Ausgang nicht übersteigt. Sind zwei redundante Kombinationen bzw. insbesondere die zwei LSB-Kombinationen zu dem MSB-Kombinations-Paar gefunden, kann nun auf Basis der Veränderung des LSB-Feldes die Abweichung von der idealen Dimensionierung in dem MSB-Feld ermittelt werden. Somit ist es also ohne zusätzliche Einrichtungen, insbesondere ohne zusätzliche analoge Schaltungstechnik, möglich, eine Vor-Ort-Kalibrierung eines Digital-Analog-Wandlers durchzuführen.

In der folgenden Erläuterung der zusätzlichen Ausführungsbeispiele wird davon ausgegangen, dass die elektrischen Bauelemente (z.B. die Kapazitäten) in dem MSB-Feld wie auch in dem LSB-Feld als binäre Elemente angeordnet sind. Des Weiteren sei bevorzugt angenommen, dass die elektrischen Bauelemente des LSB-Feldes und des MSB-Feldes im Hinblick auf ihre Anzahl und insbesondere im Hinblick auf ihre Dimensionierung gleich oder annähernd gleich sind. Diese Redundanz der Wertedarstellung (für kleine Werteveränderungen) setzt im Hinblick auf das Koppelelement zur Kopplung des LSB-Feldes und des MSB-Feldes eine ausreichend große Dimensionierung voraus, d.h. also, wenn das Koppelelement, z.B. ein Koppelkondensator, entsprechend ausgelegt ist, ohne weitere Einrichtungen ausschließlich durch geschickte Ansteuerung und durch sukzessive Approximation mittels des LSB-Feldes mittels einer MSB-Kombination und einer LSB-Kombination die Toleranzen der elektrischen Bauelemente in dem MSB-Feld ermittelbar sind. Insofern wird das Komplement typischerweise so gewählt, dass es für jeden Wert MSB1 und MSB2 mindestens einen Wert LSB1 und LSB2 gibt, der die gleiche Spannung an dem Ausgang des DA-Wandlers erzeugt.

Entsprechend Ausführungsbeispielen beziehen sich die Toleranzwerte immer auf ein Bauelement, welches der niedrigsten Bitwertigkeit in dem MSB-Feld zuordenbar ist oder auf eine Kombination von elektrischen Bauelementen, die zumindest das elektrische Bauelement mit der niedrigsten Bitwertigkeit und ein elektrisches Bauelement mit einer nächst höheren Bitwertigkeit umfasst. Auf Basis der so ermittelten Toleranzwerte kann ein Gleichungssystem aufgestellt werden, durch Lösung welches spezifische Toleranzwerte für die einzelnen elektrischen Bauelemente des MSB-Feldes ermittelbar sind.

Entsprechend weiteren Ausführungsbeispielen kann der hier beschriebene Digital-Analog-Wandler mit einem Komparator kombiniert werden, so dass ein Analog-Digital-Wandler gebildet wird.

Entsprechend bevorzugten Ausführungsbeispielen kann dieser Analog-Digital-Wandler ferner eine Nachbearbeitungseinheit umfassten, die ausgebildet ist, das Ergebnis der Digitalisierung auf Basis der selektiven Toleranzwerte bzw. allgemein auf Basis der ermittelten Toleranzwerte nachzubearbeiten bzw. zu berichtigen.

Entsprechend Ausführungsbeispielen ist es möglich über die exemplarisch als Kapazitäten realisierten elektrischen Bauelemente das mittels des AD-Wandlers zu bestimmende analoge Messsignal anzulegen, so dass durch den DA-Wandler gleichzeitig eine Abtast-Halte-Schaltung realisiert wird, da das wertemäßig abzutastende Messsignal auf den Kapazitäten des MSB-Feldes bzw. des LSB-Feldes speicherbar ist.

Weitere Ausführungsbeispiele beziehen sich auf ein Verfahren zur Kalibrierung des oben beschriebenen Digital-Analog-Wandlers. Das Verfahren umfasst hierbei die Basisschritte des Ermittelns des ersten elektrischen Signals an dem Summenpunkt unter Zuhilfenahme einer ersten MSB-Kombination und des Variierens der ersten MSB-Kombination, um eine zweite MSB-Kombination wird eine zweite LSB-Kombination ermittelt, die zusammen mit der zweiten MSB-Kombination zu einem zweiten elektrischen Signal an dem Summenpunkt führt, das abgesehen von einer messtechnischen Toleranz dem ersten elektrischen Signal gleicht. Hierbei kann wiederum in einem optionalen Schritt ein erster Toleranzwert für ein elektrisches Bauelement des MSB-Feldes (Bauelement mit niedrigster Bitwertigkeit) oder ein weiterer Toleranzwert für eine Gruppe von elektrischen Bauelementen des MSB-Feldes auf Basis der ersten und zweiten LSB-Kombination ermittelt werden.

Entsprechend weiteren Ausführungsbeispielen wird beim Ermitteln der Toleranzwerte eine Differenz zwischen der ersten und der zweiten LSB-Kombination genommen.

Ausführungsbeispiele der vorliegenden Erfindung werden nachfolgend anhand der beiliegenden Zeichnungen erläutert. Es zeigen:

Fig. 1    ein schematisches Blockschaltbild eines Digital-Analog-Wandlers in Kombination mit einer Kalibriereinheit gemäß einem ersten Ausführungsbeispiel;

Fig. 2    ein schematisches Flussdiagramm eines Verfahrens zur Kalibrierung eines Digital-Analog-Wandlers gemäß einem weiteren Ausführungsbeispiel;

Fig. 3a    ein schematisches Blockschaltbild eines Analog-Digital-Wandlers mit einem Digital-Analog-Wandler, basierend auf geschalteten Kapazitäten, gemäß einem Ausführungsbeispiel; und

Fig. 3b    ein schematisches Blockschaltbild eines Analog-Digital-Wandlers mit zwei Digital-Analog-Wandlern gemäß einem Ausführungsbeispiel.

Bevor nachfolgend Ausführungsbeispiele der vorliegenden Erfindung anhand der beiliegenden Figuren im Detail erläutert werden, sei darauf hingewiesen, dass für gleiche Elemente oder Strukturen gleiche Bezugszeichen verwendet werden, so dass die Beschreibung deren ausgetauscht werden kann bzw. aufeinander anwendbar ist.

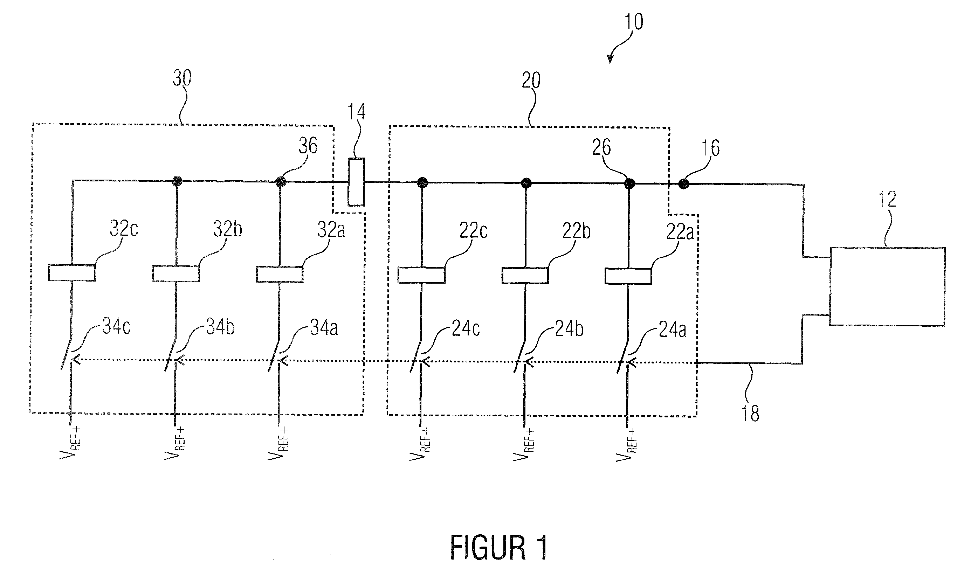

Fig. 1 zeigt einen Digital-Analog-Wandler 10 mit einer Kalibriereinheit 12. Der Digital-Analog-Wandler 10 umfasst ein MSB-Feld 20 und ein LSB-Feld 30. Sowohl das MSB-Feld 20 als auch das LSB-Feld 30 umfassen jeweils eine Mehrzahl an elektrischen Bauelementen 22a-22c für das MSB-Feld 20 bzw. 32a-32c für das LSB-Feld 30. Die elektrischen Bauelemente können beispielsweise Widerstände (R) oder Kapazitäten (C) sein und auf der einen Seite mit einem gemeinsamen Summenpunkt (vgl. MSB-Summenpunkt 26 und LSB-Summenpunkt 36) verbunden und jeweils ausgebildet, um in schaltbarer Weise mit Schaltsignalquelle $V_{REF+}$ gekoppelt zu werden, so dass ein elektrisches Schaltsignal zwischen dem Summenpunkt 26 bzw. 36 anlegbar ist (vgl. $V_{REF+}$). In diesem Ausführungsbeispiel kann die selektive Schaltfähigkeit dadurch realisiert sein, dass zu jedem der elektrischen Bauelemente 22a-22c bzw. 32a-32c ein jeweiliger Schalter 24a-24c bzw. 34a-34c zwischen dem jeweiligen elektrischen Bauelement 22a-22c bzw. 32a-32c und der elektrischen Schaltsignalquelle (vgl. $V_{REF+}$) vorgesehen ist.

Die zwei Felder 20 und 30 sind über ein gemeinsames Koppelelement 14 miteinander gekoppelt. Im Detail verbindet das Koppelelement 14, was beispielsweise auch eine Kapazität oder einen Widerstand umfassen kann, die zwei Summenpunkte 26 und 36 miteinander, so dass beispielsweise durch den Summenpunkt 26 des MSB-Feldes ein gemeinsamer Summenpunkt 16 für den gesamten Digital-Analog-Wandler 10 gebildet wird bzw. so dass die zwei Summenpunkte 26 und 36 mit dem gemeinsamen Summenpunkt 16 verbunden sind.

Die Kalibriereinheit 12 ist zumindest informatorisch mit diesem gemeinsamen Summenpunkt 16 gekoppelt und (zumindest im Kalibriermodus) dazu ausgebildet, die elektrischen Bauelemente 22a-22c bzw. 32a-32c hier über die Schalter 24a-24c bzw. 34a-34c zu schalten. Dieser Sachverhalt ist durch die zweite informatorische Kopplung (vgl.

Signalleitung 18) illustriert. Diese Signalleitung 18 kann abhängig von der jeweiligen Ausführungsform entweder durch eine direkte Vernetzung mit den Schaltern 24a-24c und 34a-34c oder durch eine informatorische Kopplung mit einer Steuereinheit (nicht dargestellt) zur Ansteuerung der Schalter 24a-24c bzw. 34a-34c realisiert sein.

Nachfolgend wird ausgehend von der oben diskutierten Struktur die Funktionsweise des Digital-Analog-Wandlers 10 erläutert, bevor im Detail auf die von der Kalibriereinheit 12 ausgeführten Schritte diskutiert werden.

Für die nachfolgende Erläuterung wird davon ausgegangen, dass die zwei Felder 20 und 30 als Kapazitätsfelder realisiert sind, die über das Koppelelement 14 bzw. die Koppelkapazität 14 miteinander gekoppelt sind. Nachfolgend wird also die Auslegung der Leitwerte der elektrischen Bauelemente 22a-22c bzw. 32a-32c anhand von Kapazitätswerten erläutert. Die Leitwerte bzw. Kapazitätswerte können beispielsweise als binäre Folge (binäre Staffelung) ausgelegt sein, d.h., dass die Kapazitäten 22a-22c bzw. die Kapazitäten 32a-32c binär zueinander gewichtet sind. Diese binäre Gewichtung kann beispielsweise auf eine Einheitskapazität $C_{EINHEIT}$ zurückgeführt werden. Für das MSB-Feld 20 ergibt sich also, dass die Kapazität 22c der Einheitskapazität $C_{EINHEIT}$ bzw. der kleinsten Kapazität in dem MSB-Feld 20 $C_0$ entspricht. Die nächst größere Kapazität 22b bzw. $C_1$ ist typischerweise doppelt so groß ausgelegt, also $2 \times C_{EINHEIT}$. Die nachfolgende Kapazität 22a bzw. $C_2$ ist hinsichtlich ihrer Größe wiederum verdoppelt, also $2 \times 2 \times C_{EINHEIT}$. Des Weiteren wird in bevorzugter Weise das zweite Kapazitätsfeld, also das LSB-Feld 30 mit den gleichen Kapazitäten implementiert. Hieraus ergibt sich:

$$C_0 = C_{LSB0} = C_{EINHEIT}$$

$$C_1 = C_{LSB1} = 2 \times C_{EINHEIT}$$

$$C_2 = C_{LSB2} = 4 \times C_{EINHEIT}$$

Für die Koppelkapazität 14 bzw. $C_{KOPPEL}$ wird typischerweise ein (Leit- bzw.) Kapazitätswert gewählt, der mindestens so groß wie die Einheits-Kapazität $C_{EINHEIT}$, bevorzugt sogar größer ist. Durch diese Dimensionierung kann erreicht werden, dass sich die binäre Staffelung der Kapazitäten von 22a nach 22c in dem zweiten Kapazitätsfeld 30 fortsetzt. Hintergrund hierzu ist, dass beispielsweise gesehen von dem Summenpunkt 16 der Schaltung 10 die Kapazität 32a bzw. 32b bzw. 32c als Seriellschaltung von Kapazitäten in Kombination mit der Koppelkapazität 14 vorliegt. Dadurch kann realisiert werden, dass gesehen von dem Summenpunkt 16 die Kapazitätswerte der Kapazitäten eines LSB-Feldes 30 binär abnehmen. In diesem Ausführungsbeispiel soll ein Schalter aller Kapazitäten des LSB-Feldes 30 einem halben Schritt des kleinsten Schrittes (vgl. Bauelement 22c), des MSB-Feldes 20 entsprechen. Unter dieser Bedingung wird typischerweise die Koppelkapazität $C_{KOPPEL}$ ausgelegt, so dass sich beispielsweise eine Dimensionierungsvorschrift in Form von $x_{koppel} > \dfrac{\left(\sum_{n=0}^{n=k}(x_n)\right) + 1}{\sum_{n=0}^{n=k}(x_n)}$ ergibt, wobei x allgemein der Leitwert ist und für das obige Ausführungsbeispiel für die Kapazität C bzw. durch einen von der Einheitskapazität $C_{EINHEIT}$ abhängigen Wert zu ersetzen ist.

Durch Aufladevorgänge bzw. durch Ladungsverschiebungsvorgänge können nun in Abhängigkeit von der jeweiligen selektiven Ansteuerung der elektrischen Bauelemente 22a-32c, die zu Umladevorgängen innerhalb der Kapazitätsanordnung 20 und 30 führen, unterschiedliche elektrische Signale bzw. Spannungen an dem Summenpunkt 16 erzeugt werden. Hierbei hat die Ansteuerung des Kondensators mit der größten Kapazität bzw. mit dem größten Leitwert, also die Ansteuerung der Kapazität 22a den größten Einfluss auf das resultierende elektrische Signal an dem Summenpunkt 16. Durch die binäre Staffelung von 22a nach 32c nimmt der Einfluss der einzelnen schaltbaren Kapazitäten 22a-32c auf das resultierende elektrische Signal ab. Insofern wird das Ansteuersignal zur Ansteuerung des Schalters 24a als Bitwert mit der höchsten Bitwertigkeit (Most Significant Bit, MSB) bezeichnet, während das Ansteuersignal zur Ansteuerung des Schalters 34c als Bitwert mit der niedrigsten Bitwertigkeit (Least Significant Bit, LSB) bezeichnet werden kann. Durch Schaltung der Schalter 24a-34c entsprechend einer digitalen Bit-Kombination, wie z.B. eine Binärkombination oder eine Bitfolge mit der Anzahl an Bits entsprechend der Anzahl an schaltbaren Kapazitäten 22a-22c, kann ein (analoges) elektrisches Signal an dem Summenpunkt 16 erzeugt werden und abgesehen von gewissen Toleranzen innerhalb eines bestimmten Bereichs exakt eingestellt werden.

Die Kombination des hier dargestellten 6-Bit-Digital-Analog-Wandlers kann aufgrund der Einteilung der schaltbaren Kapazitäten 22a-32c in die zwei Felder (MSB-Feld 20 und LSB-Feld 30) ebenso in zwei Teile untergliedert werden.

Insofern umfasst die Schalt-Kombination eine MSB-Kombination zur Ansteuerung des MSB-Feldes 20 und eine LSB-Kombination zur Ansteuerung des LSB-Feldes 30, wobei die MSB-Kombination den signifikanteren Anteil auf das resultierende elektrische Signal an dem Summenpunkt 16 hat. Von der anderen Seite betrachtet heißt das, dass Toleranzen bei der Dimensionierungen der Kapazitäten 22a-22c des MSB-Feldes sich wesentlich stärker auf das Ergebnis auswirken als Toleranzen innerhalb des LSB-Feldes 30.

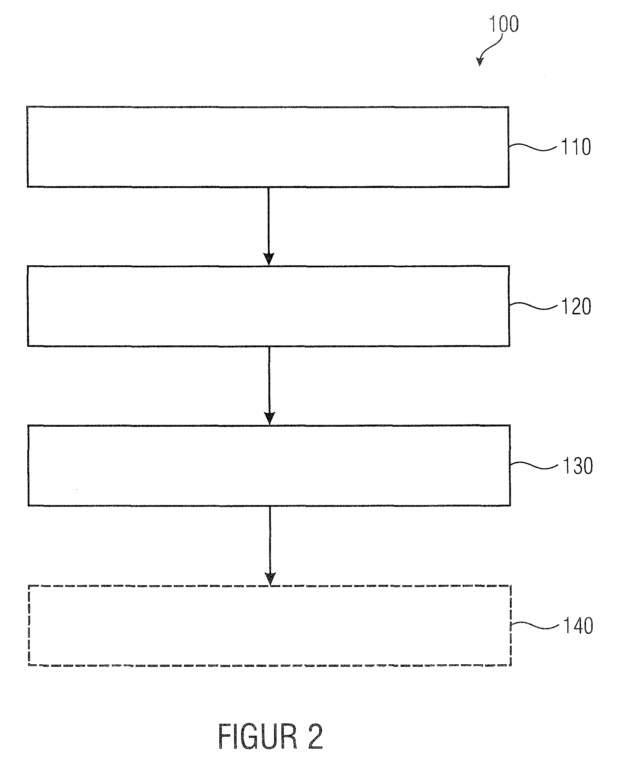

Insofern ist es vorteilhaft, dass bei der Kalibrierung zumindest Toleranzwerte derart ermittelt werden, dass auf Basis dieser eine Kalibrierung des MSB-Feldes 20 bzw. eine digitale Nachbearbeitung der MSB-Kombination möglich ist. Wie bereits oben angedeutet, ist die Koppelkapazität 14 bzw. $C_{KOPPEL}$ im Vergleich zu der Einheitskapazität $C_{EINHEIT}$ (vgl. Kondensator 22c) größer ausgelegt. Bei dem vorliegenden Ausführungsbeispiel kann diese beispielsweise mindestens mehr als 8/7 der Einheitskapazität $C_{EINHEIT}$ oder mehr betragen. Durch diese Auslegung bzw. hinreichend große Dimensionierung der Koppelkapazität 14 bzw. $C_{KOPPEL}$ kommt es zu Redundanzen im Digital-Analog-Wandler, d.h. also, dass einzelne elektrische Signale an dem Summenpunkt 16 durch unterschiedliche Kombinationen (MSB-Kombination + LSB-Kombination) darstellbar sind. Infolge dieser Redundanzen ist es möglich, das Kapazitätsfeld mit zwei redundanten Kombinationen anzusteuern und durch Vergleich der resultierenden elektrischen Signale miteinander auf eventuelle Toleranzen innerhalb des Digital-Analog-Wandlers zu schließen oder anders ausgedrückt wird bevorzugter Weise eine erste Kombination mit einer ersten MSB-Kombination und einer ersten LSB-Kombination erzeugt, das elektrische Signal an dem Summenpunkt 16 vermessen und dann die erste MSB-Kombination so variiert, dass eine redundante Kombination (LSB-Kombination und MSB-Kombination) ermittelbar ist, die zu demselben elektrischen Signal führt. Ausgehend von dieser zweiten MSB-Kombination wird in einem letzten Schritt die LSB-Kombination so lange variiert, bis sich an dem Summenpunkt ein zweites elektrisches Signal einstellt, welches mit dem ersten elektrischen Signal vergleichbar ist. Beispielsweise kann auf Basis der Differenz zwischen der ersten LSB-Kombination und der zweiten LSB-Kombination ein Toleranzwert, der Auskunft über eine Toleranz innerhalb des MSB-Feldes oder im Detail Auskunft über eine Toleranz über eine Kapazität 22c oder eine Kapazitätsgruppe 22c-22a gibt, ermittelt werden. Diese einzeln ablaufenden Schritte bei dem Suchalgorithmus zur Kalibrierung sind in Fig. 2 dargestellt.

Fig. 2 zeigt ein Verfahren 100 zur Kalibrierung eines Digital-Analog-Wandlers 10 mit den folgenden zentralen Schritten 110, 120 und 130. In dem Schritt 110 wird das erste elektrische Signal an dem Summenpunkt 16, welches infolge einer ersten MSB-Kombination (zusammen mit einer ersten LSB-Kombination) erzeugt wird, ermittelt.

Das Ermitteln kann beispielsweise durch Variieren der ersten LSB-Kombination erfolgen, so dass sich ein (beispielsweise vorbestimmtes) erstes elektrisches Signal an dem Summenpunkt 16 einstellt. Das vorbestimmte erste elektrische Signal kann beispielsweise über einen Komparator, der mit dem Summenpunkt 16 verbunden ist und ausgebildet ist, um das elektrische Signal an dem Summenpunkt 16 mit einem Referenzsignal zu vergleichen, bestimmt werden. Der Komparator gibt dann in Abhängigkeit von dem Vergleich, z.B. an die Steuerung zur Ansteuerung der Schalter 24a-24c und der Schalter 34a-34c eine binäre Information aus, die Auskunft darüber gibt, ob das an dem Summenpunkt 16 anliegende Signal größer oder kleiner im Vergleich zu einem Referenzsignal ist. Das LSB-Signal wird so lange variiert, bis das elektrische Signal an dem Summenpunkt 16 annähernd gleich dem Referenzsignal bzw. dem ersten Signal entspricht. Hierzu können unterschiedliche Algorithmen benutzt werden, die eine Variation der MSB-Kombination und insbesondere der LSB-Kombination durchführen, so dass eine Annäherung des elektrischen Signals an dem Summenpunkt 16 an das Referenzsignal möglich ist. Hierbei wird typischerweise (die MSB-Kombination bzw. insbesondere) die LSB-Kombination beginnend mit der Schaltung des Bit mit der höchsten Bitwertigkeit bis zu der Schaltung des Bits mit der niedrigsten Bitwertigkeit variiert, so dass durch ein erneutes Schalten das elektrische Signal an dem Summenpunkt 16 nicht mehr zu einer Zustandsänderung des digitalen Komparatorsignals führt. Es kann dann davon ausgegangen werden, dass das elektrische Schaltsignal (Ausgangsspannung infolge der MSB-Kombination und LSB-Kombination) sich bis auf einen Abstand, der durch das LSB (vgl. das elektrische Schaltsignal 32c) definiert ist, an das Referenzsignal (Referenzspannung) angenähert hat. Die so gefundene Kombination, bestehend aus der MSB-Kombination und LSB-Kombination, ist eine solche, die zu dem ersten elektrischen Signal führt, welche also z.B. bis auf ein LSB dem Referenzsignal entspricht. Auch wenn dieses Vorgehen insbesondere beim Einsatz des DA-Wandlers 10 in einem AD-Wandler besonders prädestiniert ist, sind auch andere Mittel zur Bestimmung des Signals an dem Summenpunkt 16 möglich.

In dem nächsten Schritt 120 wird nun die MSB-Kombination variiert bzw. durch eine zweite MSB-Kombination ersetzt. Dieser Schritt 120 kann beispielsweise unter dem Vorwissen durchgeführt werden, dass die zweite MSB-Kombination Teil einer redundanten Kombination ist, die der ersten MSB-Kombination zusammen mit der ersten LSB-Kombination zuordenbar ist. Also wird bei der Kalibrierung gezielt ein Paar von MSB-Kombinationen, bestehend aus einer ersten und einer zweiten MSB-Kombination pro Kalibriervorgang verwendet. An dieser Stelle sei angemerkt, dass je Bauelement bzw. je Bauelementegruppe typischerweise ein Paar von MSB-Kombinationen vorhanden ist, das zur Kalibrierung genutzt werden kann. Entsprechend Ausführungsbeispielen ist der Kalibrieralgorithmus deshalb derart ausgelegt, dass genau diese (vorab bekannten) MSB-Kombinationen angefahren werden. Es sei weiter angemerkt, das der Wert bei dar Variation der MSB-Kombination klein ist und ungefähr der dem LSB-Wert des MSB-Feldes 20 entspricht. Hintergrund hierzu ist, dass typischerweise eine kleine Veränderung in dem MSB-Feld, z.B. eine Veränderung des niedrigen Bitwertes in dem MSB-Feld, durch die nachfolgenden (z.B. binären) Elemente bzw. insbesondere durch die Elemente des LSB-Feldes kompensierbar sind, was soviel bedeutet, dass es für diese MSB-Code-Paare redundante Kombinationen gibt. Der Wert des MSB-Feldes von den zusammengehörenden Codes des MSB-Kombinationspaars mit der Redundanz unterscheidet sich im Regelfall um den Wert 1. Ein theoretisches Beispiel für ein derartiges redundantes Kombinationspaar ist 100 000 und 011 111. Insofern kann in der Praxis entweder von der ersten MSB-Kombination 100 oder der ersten MSB-Kombination 011 ausgegangen werden.

Um nun die Toleranz zu ermitteln, wird ausgehend von der zweiten MSB-Kombination in einem dritten Schritt 130 eine zweite LSB-Kombination, z.B. auf Basis des oben beschriebenen Algorithmus ermittelt, die in der Konsequenz zu einem zweiten elektrischen Schaltsignal führt, welches mit dem ersten elektrischen Schaltsignal im Wesentlichen übereinstimmt. Also wird bei diesem dritten Schritt 130 eine Kombination, die die zweite MSB-Kombination und die zweite LSB-Kombination umfasst, erhalten, die zu der Kombination, umfassend die erste MSB-Kombination und die erste LSB-Kombination, redundant ist. Für das Kalibrierungsverfahren, angewendet auf das obige Ausführungsbeispiel, heißt es also, dass ausgehend von der Kombination 100 bei der Ermittlung der zweiten Kombination mit der Kombination 011 111, d.h. also mit invertierten Ein- und Ausgangssignalen gestartet werden kann. Auf Basis der zwei erhaltenen LSB-Kombinationen (erste und zweite LSB-Kombination) kann nun der Fehler der Kapazitäten oder der Kapazitätsgruppe des MSB-Feldes 20 ermittelt werden oder allgemein ein Toleranzwert für ein elektrisches Bauelement 22a-22c des MSB-Feldes 20 oder für eine Gruppe von elektrischen Bauelementen 22a-22c des MSB-Feldes erhalten werden: Beispiel Code 1 MSB: 011, Code 2 MSB: 100 → Kapazitätsgruppe: $C_0+C_1+C_2$; Code 1 MSB: 010, Code 2 MSB: 011 → Kapazität: $C_0$. Die ermittelten Codes repräsentieren eine Kombination der Abweichung von der Kapazität oder der Kapazitätsgruppe von dem Nominalwert und der Abweichung von $C_{KOPPEL}$.

Entsprechend Ausführungsbeispielen ist jedes Paar an MSB-Kombinationen (erste und zweite MSB-Kombination) zur Kalibrierung eines elektrischen Schaltelements 22c bzw. zur Ermittlung eines ersten Toleranzwertes für das elektrische Schaltelement 22c oder zur Kalibrierung einer Gruppe an elektrischen Schaltelementen 22a-22c bzw. zur Ermittlung eines weiteren Toleranzwertes für die Gruppe zugeordnet. Ausgehend von der Annahme der binären Staffelung der elektrischen Schaltelemente 22a-34c kann der erste Toleranzwert für das elektrische Schaltelement 22c, welches der niedrigsten Bitwertigkeit zugeordnet ist, ermittelt werden, während die Toleranzwerte für die weiteren elektrischen Schaltelemente 22b und 22c nur in Abhängigkeit von einem Toleranzwert der elektrischen Schaltelemente, die der niedrigeren Bitwertigkeit zugeordnet sind, ermittelt werden können. Hintergrund hierzu ist, dass nur für bestimmte Kombinationen Redundanzen vorgesehen sind, und diese sich typischerweise auf solche MSB-Kombinations-Paare beschränken, bei denen die Differenz zwischen der ersten und der zweiten MSB-Kombination klein ist bzw. die niedrigste Bitwertigkeit in dem MSB-Feld 20 nicht überschreiten. Da dieser Sachverhalt insbesondere von der Dimensionierung der Koppelkapazität 14 bzw. $C_{KOPPEL}$ abhängig ist, ist die eben beschriebene Bedingung nicht zwingend. Beispielsweise kann eine vollständige Redundanz in dem System an Kombinationen erreicht werden, wenn die Koppelkapazität ausreichend groß dimensioniert ist. Beispielsweise wäre in dem vorliegenden Ausführungsbeispiel eine Dimensionierung der Koppelkapazität mit $C_{KOPPEL} \geq 16/7 \times C_0$ ausreichend. Allgemein heißt das, dass eine vollständige Redundanz dann vorhanden ist, wenn $x_{koppel} > 2 \dfrac{\left(\sum_{n=0}^{n=k}(x_n)\right)+1}{\sum_{n=0}^{n=k}(x_n)}$ ist. Beispielsweise entstehen, wenn der Wert von $C_{KOPPEL}$ zu klein ist, Bereiche, in denen das Eingangssignal nicht fehlerfrei approximiert werden kann. Daher wird $C_{KOPPEL}$ entsprechend weiteren Ausführungsbeispielen analog kalibriert oder vergrößert, um eine Mindestgröße auch bei Schwankungen zu garantieren. Es sei dennoch darauf hingewiesen, dass diese vollständige Redundanz nicht zwingend notwendig ist, da auf Basis des ersten Toleranzwertes und der ein oder mehreren weiteren Toleranzwerte, die sich auf eine Gruppe an elektrischen Bauteilen beziehen, eine Ermittlung von selektiven, d.h. bauteilspezifischen Toleranzwerten, mittels eines Gleichungssystems möglich ist.

Entsprechend weiteren Ausführungsbeispielen kann das Verfahren 100 den optionalen Schritt 140 des Lösens eines Gleichungssystems umfassen, um die bauteilspezifischen Toleranzwerte für das MSB-Feld 20 zu ermitteln.

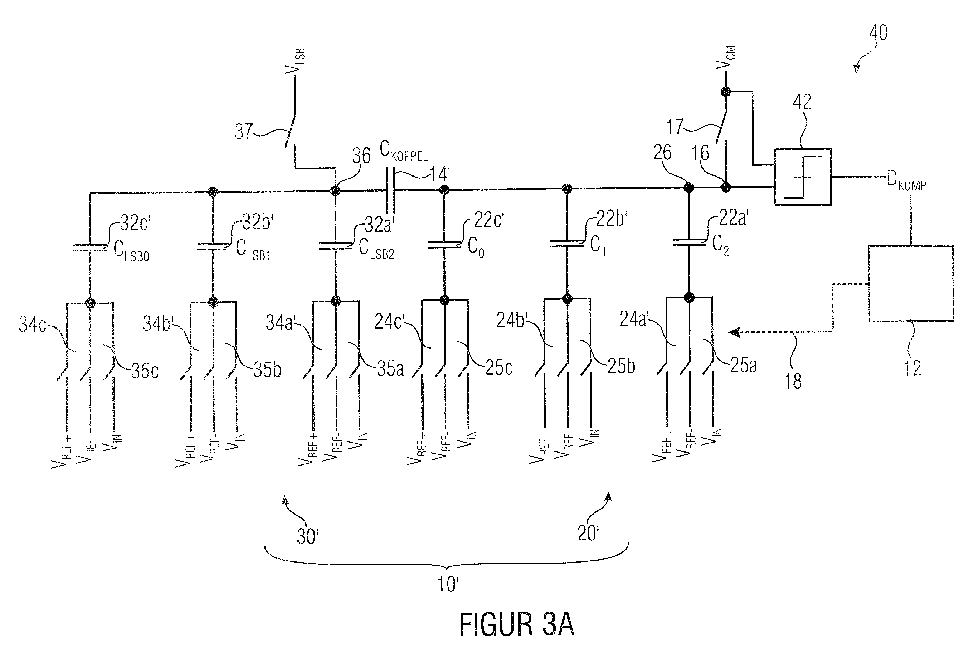

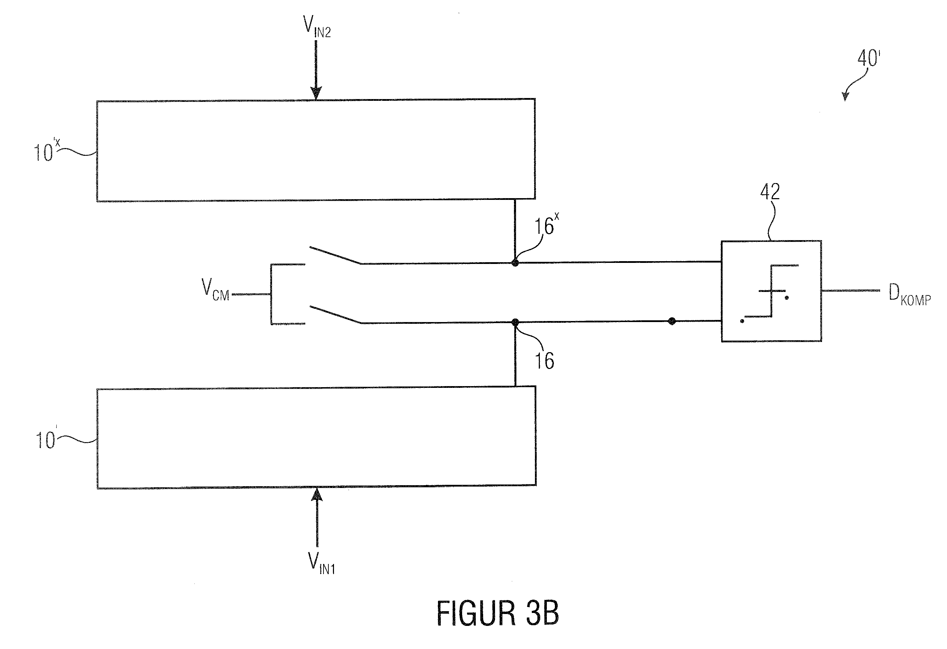

Eine exemplarische Lösung der des Gleichungssystems wird Bezug nehmend auf Fig. 3 anhand eines konkreten Ausführungsbeispiels bzw. eines Anwendungsbeispiels des oben beschriebenen Digital-Analog-Wandlers beschrieben. Hier wird Bezug nehmend auf Fig. 3a ein Analog-Digital-Wandler gezeigt, der einen Digital-Analog-Wandler, vergleichbar mit dem oben beschriebenen, umfasst, während Fig. 3b eine Abwandlung dieses Analog-Digital-Wandlers mit zwei der obigen Digital-Analog-Wandiern zeigt.

Fig. 3a zeigt einen Analog-Digital-Wandler 40 mit einem Digital-Analog-Wandler 10' und einem Komparator 42, der mit einem Signaleingang mit dem Summenpunkt 16 des Digital-Analog-Wandlers 10' verbunden ist. Der digitale Ausgang $D_{Komp}$ des Komparators 42 ist über die Kalibriereinheit 12, welche beispielsweise als FPGA gestaltet sein oder allgemein einen CPU umfassen kann, der ausgebildet ist, den oben beschriebenen Kalibrieralgorithmus durchzuführen, verbunden. Die Kalibriereinheit 12 ist, wie oben beschrieben, mit den Elementen zur selektiven Schaltung der Kapazitäten (elektrischen Bauelemente) 22a'-22c' bzw. 32a'-32c' des Digital-Analog-Wandlers 10' gekoppelt (vgl. Signalleitung 18).

Der Digital-Analog-Wandler 10', wiederum ein 6-Bit-Digital-Analog-Wandler, umfasst das MSB-Feld 20' und das LSB-Feld 30', wobei die elektrischen Bauelemente 22a'-22c' und 32a'-32c' als Kapazitäten ausgeführt sind. Die Dimensionierung entsprechend einer mathematischen Folge ist so gewählt, dass $x_n = 2 x_{n-1}$ gilt bzw. dass $C_n = 2 \times C_{n-1}$ gilt. Insofern ist die oben aufgeführte Auslegung der Kapazitäten in Abhängigkeit von $C_0$ bzw. in Abhängigkeit von $C_{EINHEIT}$ weiterhin gültig. Ebenso ist die Dimensionierung von $C_{KOPPEL}$ bzw. dem Koppelelement 14 analog zu dem oben beschriebenen.

Ein Wesentlicher Unterschied zwischen dem Digital-Analog-Wandler 10' und dem Digital-Analog-Wandler 10 ist, dass die Schaltung der elektrischen Bauelemente 22a'-22c' bzw. 32a'-32c' mittels zwei unterschiedlichen Schaltspannungen, nämlich $V_{REF+}$ und $V_{REF-}$ erfolgt. Diese zwei Schaltsignalquellen bzw. Spannungsquellen sind jeweils auf einer ersten Seite des jeweiligen elektrischen Schaltelements 22a'-22c' bzw. 32a'-32c' angeordnet bzw. mit einem Schalter gegenüber der einen Kondensatorplatte verknüpft, so dass mit den beiden Schaltsignalen bzw. Spannungen $V_{REF+}$ und $V_{REF-}$ die einzelnen elektrischen Schaltelemente 22a'-22c' und 32a'-32c' selektiv aktivierbar bzw. deaktivierbar sind. Hierbei erfolgt eine Aktivierung der jeweiligen elektrischen Bauelemente 22a'-22c' bzw. 32a'-32c' über die Schaltelemente (Doppelschalter) 24a'-24c' bzw. 34a'-34c' mittels des Schaltsignals $V_{REF+}$, während eine Deaktivierung mittels des Schaltsignals $V_{REF-}$ erfolgt. Somit wird also mittels einer binären 0 in der MSB-Kombination bzw. der LSB-Kombination das Schaltsignal $V_{REF-}$ auf die jeweiligen elektrischen Bauelemente 22a'-22c' bzw. 32a'-32c' geschaltet, während mittels einer binären 1 das reguläre Schaltsignal $V_{REF+}$ auf die jeweiligen Schaltelemente 22a'-22c' bzw. 32a'-32c' geschaltet werden. $V_{REF-}$ kann, muss aber nicht notwendigerweise, das invertierte Schaltsignal zu $V_{REF+}$ sein, sollte jedoch in Bezug auf den absoluten Wert von $V_{REF+}$ zumindest kleiner sein.

Bei diesem Ausführungsbeispiel des Analog-Digital-Wandlers wird das zu quantifizierende Messsignal $V_{IN}$ auf der ersten Seite der elektrischen Bauelemente 22a'-22c' bzw. 32a'-32c' angelegt. Das Anlegen erfolgt mittels eines Schalters (vgl. 25a-25c, 35a- 35c), so dass das Signal bzw. die sich infolge des Anlegens des Signals $V_{IN}$ in einstellenden Ladungen speicherbar ist. D.h. also, dass die Funktionalität einer sogenannten Sample-Hold-Schaltung durch den Digital-Analog-Wandler 10' hergestellt wird. Die zweite Seite der elektrischen Bauelemente 22a'-22c' wird bei dem Vorgang des Einlesens und Speicherns des Messsignals $V_{IN}$ mit einem Referenzsignal $V_{CM}$ für das MSB-Feld 20' bzw. $V_{LSB}$ für das LSB-Feld 30' gekoppelt, so dass das Messsignal $V_{in}$ gegenüber diesen Signalen anlegbar ist. Hierzu ist also der Summenpunkt 16 bzw. der Summenpunkt 26 in schaltbarer Weise (Schalter 17) mit einer Referenzspannungsquelle $V_{CM}$ verbunden, während der Summenpunkt 36 in schaltbarer Weise (Schalter 37) mit einer Referenzspannungsquelle $V_{LSB}$ verbunden ist. Hierbei sei angemerkt, dass $V_{LSB}$ gleich $V_{CM}$ sein kann, aber nicht muss. Das Referenzsignal $V_C$ liegt typischerweise an dem zweiten Komparatoreingang des Komparators 42 an.

Die Umsetzung bei der Analog-Digital-Wandlung erfolgt typischerweise wie folgt. Die Kapazitäten 22a'-22c' bzw. 32a'-32c' werden über die Schalter 25a-25c, 35a- 35c mit dem Messsignal $V_{IN}$ verbunden, so dass die Kapazitäten 22a'-22c' bzw. 32a'-32c' durch die Spannungsdifferenz zwischen $V_{in}$ und dem jeweiligen Referenzsignal $V_{LSB}$ bzw. $V_{CM}$, wenn diese mit den jeweiligen Summenpunkten (LSB-Summenpunkt 36 bzw. MSB-Summenpunkt 32) gekoppelt (vgl. Schalter 17 und 37) sind, geladen werden kann. Danach werden die Schalter 25a-25c, 35a- 35c, 17, 37 für $V_{IN}$, $V_{LSB}$ und $V_{CM}$ geöffnet, wobei die sich auf der Kapazitätsanordnung 20' plus 30' einstellende Ladung erhalten bleibt, so dass diese in einem nächsten Schritt ausgemessen werden kann. Hierbei erfolgt das Vermessen des Messsignals unter Zuhilfenahme des Komparators 42, der z.B. die elektrische Spannung an dem Summenpunkt 16 mit $V_{CM}$ vergleicht und so ermittelt, ob das elektrische Signal an 16' größer oder kleiner als der angelegte Wert $V_{CM}$ ist. Dieser Schritt des Vergleichens des anliegenden Signals an den Summenpunkt mit dem Referenzsignal $V_{CM}$ unter Zuhilfenahme des Komparators 42 wird nun entsprechend wiederholt, wobei die Schalterstellungen 24a'-24c' und/oder 34a'-34c' für das MSB-Feld 20' und/oder das das LSB-Feld 30' in Abhängigkeit von der Komparatorentscheidung (vgl. $D_{Komp}$) angepasst wird.

Beispielsweise könnte die Variation wie folgt erfolgen:

Anlegen von $C_{LSB0} = V_{REF-}$; $C_{LSB1} = V_{REF-}$; $C_{LSB2} = V_{REF-}$; $C_0 = V_{REF-}$; $C_1 = V_{REF-}$; $C_2 = U_{REF+}$;
Wenn $D_{Komp} = 1$ ist, folgt als nächster Test: $C_{LSB0} = V_{REF-}$; $C_{LSB1} = V_{REF-}$; $C_{LSB2} = V_{REF-}$; $C_0 = V_{REF-}$; $C_1 = U_{REF+}$; $C_2 = V_{REF-}$; oder
wenn $D_{Komp} = 0$ ist, folgt als nächster Test: $C_{LSB0} = V_{REF-}$; $C_{LSB1} = V_{REF-}$; $C_{LSB2} = U_{REF-}$; $C_0 = V_{REF-}$; $C_1 = V_{REF+}$; $C_2 = V_{REF+}$;

D.h. also, dass zumindest eine Kapazität auf $V_{REF+}$ gesetzt wird. Wenn der Komparator danach auf 1 geht, dann wird diese wieder mit $V_{REF-}$ verbunden, sonst bleibt sie auf $V_{REF+}$. Dieses Vorgehen wird dann mit der nächst geringeren Kapazität wiederholt. Zuerst für das MSB-Feld 20' und dann für das LSB-Feld 30'. Insofern erfolgt die Ermittlung des Analog-Digital-Signals, wie oben bereits erläutert, unter Variation der MSB-Kombination und der LSB-Kombination. Das so gefundene Ergebnis stellt sich in Form einer Kombination, bestehend aus der LSB-Kombination und der MSB-Kombination, dar, wobei dieses durch die bei der Kalibrierung ermittelten Korrekturfaktoren mittels einer Nachbearbeitungseinrichtung (nicht dargestellt) korrigiert werden kann. Die Nachbearbeitungseinrichtung kann z.B. auf den mathematischen Operatoren Summe und/oder Addition basieren, um so das Ergebnis der AD-Wandlung bitweise unter Verrechnung der für den DA-Wandler ermittelten Korrekturwerte zu korrigieren. Es sei angemerkt, dass die Korrekturwerte typischerweise unabhängig von dem Offset des Komparators 42, jedoch abhängig von $C_{KOPPEL}$ sind, wobei der Einfluss von $C_{KOPPEL}$ verschwindet, da dieser in allen Korrekturwerten gleich ist.

Für dieses Ausführungsbeispiel des Analog-Digital-Wandlers 40 gibt es insgesamt zwei bevorzugte Kalibrierungsverfahren. Das erste Kalibrierungsverfahren entspricht grundsätzlich dem oben beschriebenen Verfahren und kann als Vordergrund-Kalibrierung bezeichnet werden. Hier wird statt des Eingangssignals $V_{IN}$ ein vorgegebener Code (z.B. Code 1) an die Kapazitäten 22a'-22c' bzw. 32a'-32c' angelegt. Nachdem dieses Signal auf die Kapazitäten 22a'-22c' bzw. 32a'-32c' gespeichert ist, wird der binäre Wert des MSB-Feldes 20' um einen Schritt verändert. Es hängt vom angegebenen Code (Code 1) ab, ob der Wert des MSB-Feldes 20' erhöht oder verringert wird. Die LSB-Codes (erster und zweiter LSB-Code bzw. Code 2 und 3) werden mit dem normalen Algorithmus ermittelt. Die Differenz zwischen den beiden binären LSB-Codes wird als Korrekturwerte gespeichert. Hierbei wird der vorgegebene Code (Code 1) mit dem SAR-Algorithmus umgesetzt, während der so ermittelte erste LSB-Code (Code 2) für die Differenzbildung mit dem zweiten LSB-Code (Code 3) verwendet wird. D.h. die Differenz zwischen den beiden binären LSB-Codes (erster und zweiter LSB-Code bzw. Code 2 und Code3) kann als Korrekturwert gespeichert werden.

Entsprechend einer zweiten Kalibriervariante ist es möglich, die Kalibrierung während des laufenden Betriebs durchzuführen. Diese Kalibriervariante wird als Hintergrund-Kalibrierung bezeichnet und bevorzugt dann angewendet, wenn damit zu rechnen ist, dass die Eingangssignale $V_{IN}$ eine genügend große Varianz aufweisen.

In dem Fall der Hintergrund-Kalibrierung wird der Analog-Digital-Wandler 40 zum Umsetzen des Eingangssignals $V_{IN}$ betrieben. Nachdem das Eingangssignal $V_{IN}$ das erste Mal quantifiziert wurde, wird der Algorithmus zur Quantifizierung so geändert, dass eine zweite Umsetzung des gleichen Signals möglich ist. Dies entspricht also der Umsetzung eines Signals mit zwei redundanten Kombinationen. Falls ein zweiter Code mit einer zweiten MSB-Kombination, also einer gegenüber der ersten MSB-Kombination bei der ersten Umsetzung unterschiedliche MSB-Code, ermittelt werden kann, kann in Abhängigkeit von dem zweiten ermittelten LSB-Code der Kapazitätsfehler einer Kapazität oder einer Kapazitätsgruppe ermittelt werden. So ist es also möglich, die Kalibrierung während des laufenden Betriebs durchzuführen. Dieser Algorithmus kann entsprechend zusätzlichen Ausführungsbeispielen dadurch beschleunigt werden, dass die Menge der möglichen Lösungen für die zweite MSB-Kombination begrenzt ist. Insofern wird entsprechend weiteren Ausführungsbeispielen der Suchalgorithmus bei der Kalibrierung so ausgelegt, dass er die Begrenzung der zweiten MSB-Kombination berücksichtigt.

Im Gegensatz zu der Vordergrund-Kalibrierung, bei der entsprechend einer logischen Sequenz die MSB-Kombinationen angefahren werden, die zur Kalibrierung der einzelnen elektrischen Bauelemente bzw. Bauelementegruppe dienen, ist hier das Anfahren der einzelnen MSB-Kombinationen von dem Messsignal $V_{IN}$ abhängig. Aufgrund dessen kann es vorkommen, dass ein Toleranzwert dasselbe elektrische Bauelement bzw. dieselbe elektrische Bauelementegruppe mehrmals erhalten wird. Hierbei kann entsprechend einer ersten Variante der alte Wert durch den neuen ersetzt werden oder entsprechend einer zweiten Variante die zweiten Werte miteinander verrechnet werden (z.B. Mittelung, gewichtete Mittelung). Auf diese Weise können Schwankungen der Kalibrierwerte über die Zeit hinaus ausgeglichen werden.

Unterm Strich liefert sowohl die Vordergrund- als auch die Hintergrund-Kalibrierung Korrekturwerte für das Schalten von $C_0$, für das Schalten von $C_0+C_1$ und für das Schalten von $C_0+C_1+C_2$. Diese Werte D0, D01, und D012 werden nun im normalen Betrieb angewendet, um den Ausgangsbitstrom des ADCs zu korrigieren. Die Ermittlung der Korrekturwerte D0, D01 und D012 werden nun anhand eines mathematischen Beispiels beschrieben. Hierbei sind A0, A1 und A2 die MSB-Bits der MSB-Kombination, die die Werte 0 und 1 annehmen können. D0, D1 und D2 sind ebenfalls die Werte der MSB-Kombination, wobei hier der Wertebereich -1 oder 1 umfasst. ALSB1 sind die LSB-Bits der LSB-Kombination bei dem Start der Kalibrierung, während ALSB2 die LSB-Bits nach der Umsetzung sind. ALSBX ist eine reele Zahl zwischen -1 (alle LSB-Bits = 0) und 1 (alle LSB-Bits = 1).

Definition Gleichungen

$$\text{In[11]:= ChargeMSBconv[n\_] :=}$$
$$\text{Total}\left[\text{Table}\left[(V_{CMP} - \text{Subscript}[a,i] * V_{REF}) \, 2^i \, Cu(1+ \text{Subscript}[e,i]),\right.\right.$$
$$\left.\left.\{i,0,n-1\}\right]\right] + (V_{CMP} - V_{LSB}) \, cCu$$

$$\text{In[12]:= ChargeMSBsampCal[n\_] :=}$$
$$\text{Total}\left[\text{Table}\left[(0 - \text{Subscript}[b,i] * V_{REF}) \, 2^i \, Cu(1+ \text{Subscript}[e,i]),\right.\right.$$
$$\left.\left.\{i,0,n-1\}\right]\right] + (0-0) \, cCu$$

In[13]:= ChargeMSBsampNorm[n_] :=

$$\text{Total}[\text{Table}[(0 - \text{Vin}) \, 2^{\wedge}i \, \text{Cu}(1 + \text{Subscript}[e,i]), \{i,0,n-1\}]] + (0-0) \, \text{cCu}$$

In[14]:= ChargeLSBconv[n_] :=

$$\text{Total}[\text{Table}[(V_{LSB} - \text{Subscript}[a, LSB2] * V_{REF}) \, 2^{\wedge}i \, \text{Cu}, \{i, 0, n-1\}]] +$$
$$(V_{LSB} - V_{CMP}) \, \text{cCu}$$

In[15]:= ChargeLSBsamp[n_] :=

$$\text{Total}[\text{Table}[(0 - \text{Subscript}[a, LSB1] * V_{REF}) \, 2^{\wedge}i \, \text{Cu}, \{i, 0, n-1\}]] + (0-0) \, \text{cCu}$$

Umrechnungsformel im Betrieb

In[16]:= EquSignal = {ChargeMSBconv[3] ChargeMSBsampNorm[3], ChargeLSBconv[3] ChargeLSBsamp[3]} // FullSimplify

$$\text{Out[16]}= \{\text{Cu}(\text{Vin}(7 + e_0 + 2e_1 + 4e_2) + (7 + c + e_0 + 2e_1 + 4e_2) V_{CMP} -$$
$$cV_{LSB} - (a_0(1 + e_0) + 2(a_1(1 + e_1) + 2a_2(1 + e_2))) V_{REF}) = 0,$$
$$\text{Cu}(cV_{CMP} - (7 + c) V_{LSB} + 7(-a_{LSB1} + a_{LSB2}) V_{REF}) = 0\}$$

Umrechnungsformel bei Kalibrierung

In[17]:= EquCal = {ChargeMSBconv[3] ChargeMSBsampCal[3], ChargeLSBconv[3] ChargeLSBsamp[3]} // FullSimplify

$$\text{Out[17]}= \{\text{Cu}((7 + c + e_0 + 2e_1 + 4e_2) V_{CMP} - cV_{LSB} + (b_0 + b_0 e_0 - a_0(1 + e_0) -$$
$$2a_1(1 + e_1) - 4a_2(1 + e_2) + 2(b_1(1 + e_1) + 2b_2(1 + e_2))) V_{REF}) = 0,$$
$$\text{Cu}(cV_{CMP} - (7 + c) V_{LSB} + 7(-a_{LSB1} + a_{LSB2}) V_{REF}) = 0\}$$

In[18]:= startCode = Table[i,{i,0,6}];

Gleichungen um die zwei passenden Codes zu finden

In[19]:= EquArray = Map[EquCal I. $\{a_0\ \text{-4}\ 2^*\ d0\text{-}\ 1,\ a_1\ \text{-4}\ 2^*\ d1\text{-}\ 1,\ a_2\ \text{-4}\ 2^*\ d2\text{-}\ 1\}$ I. d2 -4 BitGet[I: + 1,2]

I. d1 -4 BitGet[I: + 1, 1] I. d0 -4

BitGet[I: + 1,0]

I. $\{b_0\ \text{-4}\ 2^*\ d0\text{-}\ 1,\ b_1\ \text{-4}\ 2^*\ d1\text{-}\ 1,\ b_2\ \text{-4}\ 2^*\ d2\text{-}\ 1\}$ I. d2 -4 BitGet[I:,

2]

I. d1 -4 BitGet[I:, 1] I. d0 -4

BitGet[I:,0]

I.$\{V_{CMP}\ \text{-4}\ 0\}$ &,startCode] II FullSimplify

Out[19]= $\{\{cCuV_{LSB} + 2Cu(1+ e_0)\ V_{REF} = 0, (7+ c)\ CuV_{LSB} + 7Cu(a_{LSB1} - a_{LSB2})\ V_{REF} = 0\},$
$\{cCuV_{LSB} = 2Cu(-1+ e_0 - 2e_1)\ V_{REF}, (7+ c)\ CuV_{LSB} + 7Cu(a_{LSB1} - a_{LSB2})\ V_{REF} = 0\},$
$\{cCuV_{LSB} + 2Cu(1+ e_0)\ V_{REF} = 0, (7+ c)\ CuV_{LSB} + 7Cu(a_{LSB1} - a_{LSB2})\ V_{REF} = 0\},$
$\{cCuV_{LSB} = 2Cu(-1+ e_0 + 2e_1 - 4e_2)\ V_{REF}, (7+ c)\ CuV_{LSB} + 7Cu(a_{LSB1} - a_{LSB2})\ V_{REF} = 0\},$
$\{cCuV_{LSB} + 2Cu(1+ e_0)\ V_{REF} = 0, (7+ c)\ CuV_{LSB} + 7Cu(a_{LSB1} - a_{LSB2})\ V_{REF} = 0\},$
$\{cCuV_{LSB} = 2Cu(-1+ e_0 - 2e_1)\ V_{REF}, (7+ c)\ CuV_{LSB} + 7Cu(a_{LSB1} - a_{LSB2})\ V_{REF} = 0\},$
$\{cCuV_{LSB} + 2Cu(1+ e_0)\ V_{REF} = 0, (7+ c)\ CuV_{LSB} + 7Cu(a_{LSB1} - a_{LSB2})\ V_{REF} = 0\}\}$

Hinweis: A_LSB1 ist der LSB-Binärcode beim Sampeln, A_LSB2 ist der LSB-Binärcode noch dem Umsetzen. d01 ist die different von A_LSB1 - A_LSB2 beim Umschalten des MSB Feldes von 0 nach 1

In[20]:= Res3e0 = $e_0$ I.Solve[EquArray[[2^0]],$\{e_0, V_{LSB}\}$] II First
Res3e0 = % II. $\{(a_{LSB1} - a_{LSB2})\ \text{-4}\ d01\}$

Out[20]= $-1 + \dfrac{7c(a_{LSB1} - a_{LSB2})}{2(7+ c)}$

Out[21]= $-1 + \dfrac{7cd01}{2(7+ c)}$

Hinweis: A_LSB1 ist der LSB-Binärcode beim Sampeln, A_LSB2 ist der LSB-Binärcode noch dem Umsetzen. d12 ist die different von A_LSB1-A_LSB2 beim Umschalten des MSB Feldes von 1 nach 2

In[22]:= Res4e1 = $e_1$ I. Solve[EquArray[[2^1]] II. $e_0$ -4 Res3e0, $\{e_1, V_{LSB}\}$] II First II
FullSimplify
Res4e1 = % II. $\{a_{LSB1}\ \text{-4}\ d12\ I\ 2, a_{LSB2}\ \text{-4}\ \text{-}d12\ I\ 2\}$

Out[22] = $\dfrac{-4(7+ c) + 7cd01 + 7ca_{LSB1} - 7ca_{LSB2}}{4(7+ c)}$

$\dfrac{-4(7+ c) + 7cd01 + 7cd12}{4\ (7+\ c)}$

Out[23]=

In[24]:= Res5e2 =

$e_2$ I.Solve[EquArray[[2^2]] II. {$e_0$ -4 Res3e0, $e_1$ -4 Res4e1}, {$e_2$, $V_{LSB}$}] II
First II FullSimplify

Res5e2 = % II. {$a_{LSB1}$ -4 d34 I 2, $a_{LSB2}$ -4 -d34 I 2}

$$Out[24] = \frac{-56 + c(-8 + 14d01 + 7d12) + 7ca_{LSB1} - 7ca_{LSB2}}{8(7 + c)}$$

$$\frac{-56 + c(-8 + 14d01 + 7d12) + 7cd34}{8(7 + c)}$$

Out[25 Conversion ]=

In[27]:= EquSignal I. {$V_{CMP}$ -4 0, $a_{LSB1}$ -4 0} I.{$e_0$ -4 Res3e0, $e_1$ -4 Res4e1, $e_2$ -4 Res5e2}

$$Out[27] = Cu\left(\left(6 + \frac{7cd01}{2(7+c)} + \frac{-4(7+c) + 7cd01 + 7cd12}{2(7+c)} + \frac{-56 + c(-8 + 14d01 + 7d12) + 7cd34}{2(7+c)}\right)\right.$$

$$Vin - cV_{LSB} - \left(\frac{7cd01a_0}{2(7+c)} + 2\left(\left(1 + \frac{-4(7+c) + 7cd01 + 7cd12}{4(7+c)}\right)a_1 + \right.\right.$$

$$2\ 1 + \left(\frac{-56 + c(-8 + 14d01 + 7d12) + 7cd34}{8(7+c)}\right)a_2\left)\right)$$

$$V_{REF} = 0, Cu(-(7+c)V_{LSB} + 7a_{LSB2}V_{REF}) = 0$$

Korrekturformel

In[28]:= RealIn = Vin I. Solve[%, {Vin, $V_{LSB}$}] II First

$$(d01a_0 + d01a_1 + d12a_1 + 2d01a_2 + d12a_2 + d34a_2 + 2a_{LSB2})V_{REF}$$

Out[28]=

4d01 + 2d12 + d34

Der Bezug nehmend auf Fig. 3a gezeigte Analog-Digital-Wandler, der zur Verarbeitung eines Single-Ended-Signals ausgebildet ist, kann auch zur Verarbeitung von differenziellen Signalen konfiguriert werden, wie in Fig. 3b gezeigt ist.

Fig. 3b zeigt einen Analog-Digital-Wandler 40' mit dem Komparator 42 und zwei Digital-Analog-Wandlern 10' und 10'$^x$.Der erste der zwei Digital-Analog-Wandler 10' ist über den Summenpunkt 16 mit einem ersten Eingang des Komparators 42 mit demselben gekoppelt, während der Digital-Analog-Wandler 10'$^x$ über den Summenpunkt 16$^x$ mit dem zweiten Komparatoreingang gekoppelt ist. Ferner kann eine Referenzspannungsquelle (vgl. $V_{CM}$) vorgesehen sein, die in schaltbarer Weise mit den Summenpunkten 16 und 16$^x$ verbindbar ist. Zur differenziellen Ansteuerung wird der erste Messsignalteil $V_{IN1}$ an dem ersten Digital-Analog-Wandler 10' angelegt, während der zweite Messsignalteil $V_{IN2}$ über den zweiten Digital-Analog-Wandler 10'$^x$ angelegt wird. Die beiden Digital-Analog-Wandler 10' und 10'$^x$ werden grundsätzlich analog zu dem obigen Ausführungsbeispiel betrieben, wobei jedoch bei der Umsetzung jeweils die invertierten Schaltsignale $V_{REF+}$ bzw. $V_{REF-}$ anliegen.

Obwohl bei obigen Ausführungsbeispielen immer davon ausgegangen wurde, dass die MSB- / LSB-Felder zumindest drei schaltbare elektrische Bauelemente umfassen, sei darauf hingewiesen, dass die Anzahl je Feld auch variieren kann, so dass zumindest zwei elektrische Bauelemente, bevorzugt aber eine Vielzahl von elektrischen Bauelementen je MSB- bzw. LSB-Feld vorgesehen sind. D.h. also, dass beispielsweise auch eine C2C-Architektur zur Realisierung des Digital-Analog-Wandlers möglich wäre, auf die ebenso das oben beschriebene Verfahren zur Kalibrierung anwendbar ist. Des Weiteren sei darauf hingewiesen, dass nicht zwingendermaßen jedes der elektrischen Bauelemente schaltbar ausgeführt sein kann, so dass beispielsweise fixe elektrische Bauelemente bzw. fixe Kapazitäten oder fixe Widerstände vorgesehen sein können.

Ebenso ist entsprechend weiteren Ausführungsbeispielen die Anzahl der verwendeten Bauelementefelder nicht auf die zwei (MSB- und LSB-Bauelementefeld) limitiert. Insofern können ein weiterer oder mehrere weitere LSB-Bauelementefelder vorgesehen sein, die zur Kalibrierung des MSB-Feldes oder auch zur Kalibrierung von höher geordneten LSB-Feldern genutzt werden können.

Entsprechend weiteren Ausführungsbeispielen kann, wie oben bereits angedeutet, anstelle der elektrischen Bauelemente, die als Kapazitäten beschrieben wurden, auch Widerstände für die elektrischen Bauelemente in dem MSB-, dem LSB-Feldes und das elektrische Bauelement zur Kopplung der zwei Felder verwendet werden. Hierbei entspricht dann der Widerstandswert R dem Leitwert x. Es sei ebenso auf die sogenannte R2R-Architektur hingewiesen, die ebenso eine Realisierung eines Digital-Analog-Wandlers ermöglicht und entsprechend dem oben beschriebenen Verfahren kalibrierbar ist.

Auch wenn bei obigen Ausführungsbeispielen immer von einer sogenannten binären Gewichtung der elektrischen Bauelemente zueinander ausgegangen wurde, sei darauf hingewiesen, dass dies nicht zwingend für den Erfindungsgedanken ist. So können beispielsweise die elektrischen Bauelemente auch entsprechend einer anderen mathematischen Folge angeordnet sein. So ist es beispielsweise möglich, dass sich die einzelnen Wertebereiche überlappen, was insofern Einfluss auf die Kalibrierung hat, da hier die Anzahl an redundanten Werten zunimmt. Bei einer nicht vollständig besetzten mathematischen Folge entsteht der umgekehrte Effekt, so dass nicht jeder Wert redundant bzw. nicht jeder Wert darstellbar ist. Bei derartig variierten Gewichtungen der Dimensionierung der elektrischen Bauelemente des Digital-Analog-Wandlers ist das oben beschriebene Prinzip ebenso anwendbar.

Bezug nehmend auf Fig. 1 sei angemerkt, dass parallel zu dem Schalter 24c bzw. allgemein parallel zu den Schaltern 24a-24c bzw.34a-34c jeweils ein weiterer Schalter vorgesehen sein kann, der das jeweilige Bauelement 22a-22c bzw.32a-32c mit einer weiteren Schaltspannung verbindet.

Bezug nehmend auf Fig. 3a sei angemerkt, dass das Messsignal $V_{IN}$ nicht zwingenderweise über den Digital-Analog-Wandler angelegt werden muss, sondern dass es auch möglich ist, das Messsignal beispielsweise über den Referenzsignaleingang des Komparators 42, also über den zweiten Komparatoreingang anzulegen. Hierbei könnte auch entsprechend einem zusätzlichen Ausführungsbeispiel eine Sample-Hold-Schaltung an dem Komparatoreingang vorgesehen sein.

Nachfolgend werden weitere Ausführungsbeispiele der Erfindung beschrieben. Ein erstes Ausführungsbeispiel schafft einen Digital-Analog-Wandler (10, 10'), mit folgenden Merkmalen:

einem MSB-Feld (20, 20') mit einer Mehrzahl an elektrischen Bauelementen (22a-22c, 22a'-22c'), die einen gemeinsamen MSB-Summenpunkt (26) bilden und jeweils selektiv entsprechend einer MSB-Kombination mittels eines elektrischen Schaltsignals ($V_{REF+}$, $V_{REF-}$) beaufschlagbar sind, wobei die Mehrzahl der elektrischen Bauelementen (22a-22c, 22a'-22c') unterschiedliche Leitwerte x (R, $C_{EINHEIT}$, $C_0$, $C_1$, $C_2$) aufweisen, die entsprechend einem Ausschnitt einer mathematischen Folge mit $x_n = f(x_{n-1})$ in Relation zueinander stehen und/oder um jeweilige Toleranzwerte von der mathematischen Folge $x_n = f(x_{n-1})$ abweichen;

einem LSB-Feld (30, 30') mit einer zweiten Mehrzahl der elektrischen Bauelemente (32a-32c, 32a'-32c'), die einen gemeinsamen LSB-Summenpunkt (36) bilden und jeweils entsprechend einer LSB-Kombination mittels des elektrischen Schaltsignals ($V_{REF+}$, $V_{REF-}$) beaufschlagbar sind;

einem Koppelelement (14, 14'), über welches der LSB-Summenpunkt (36) und der MSB-Summenpunkt (26) miteinander gekoppelt sind; und

einer Kalibriereinheit (12), die ausgebildet ist, um die jeweiligen Toleranzwerte für die elektrischen Bauelemente (22a-22c, 22a'-22c') des MSB-Feldes (20, 20') zu ermitteln,

wobei durch die elektrischen Bauelemente (22a-22c, 32a-32c, 22a'-22c', 32a'-32c') des MSB-Feldes (20, 20') und des LSB-Feldes (30, 30') bei Anliegen des elektrischen Schaltsignals ($V_{REF+}$, $V_{REF-}$) ein elektrisches Signal an einem Summenpunkt (16), welcher mit dem MSB-Summenpunkt (26) und dem LSB-Summenpunkt (36) gekoppelt ist, erzeugt wird, wobei das elektrische Signal von der MSB-Kombination und der LSB-Kombination abhängig ist,

wobei die Kalibriereinheit (12) ausgebildet ist, um ein sich infolge einer ersten MSB-Kombination einstellendes, erstes elektrisches Signal an dem Summenpunkt (16) unter Berücksichtigung einer ersten LSB-Kombination zu ermitteln, wobei die Kalibriereinheit (12) ausgebildet ist, um die erste MSB-Kombination zu variieren, um eine zweite MSB-Kombination zu erhalten, und wobei die Kalibriereinheit (12) ausgebildet ist, um ausgehend von der zweiten MSB-Kombination eine zweite LSB-Kombination zu ermitteln, die zusammen mit der zweiten MSB-Kombination zu einem zweiten elektrischen Signal an dem Summenpunkt (16) führt, das in seiner Toleranzbehaftung dem ersten elektrischen Signal gleicht,

wobei die zweite LSB-Kombination zusammen mit der ersten LSB-Kombination Auskunft über einen ersten Toleranzwert für ein elektrisches Bauelement des MSB-Feldes (20, 20') oder Auskunft über einen weiteren Toleranzwert für eine Gruppe von elektrischen Bauelementen (22a-22c, 22a'-22c') des MSB-Feldes (20, 20') gibt.

Bei einem zweiten Ausführungsbeispiel gemäß dem ersten Ausführungsbeispiel umfassen die elektrischen Bauelemente (22a-22c, 32a-32c, 22a'-22c', 32a'-32c') und das Koppelelement (14, 14') jeweils mindestens eine Kapazität.

Bei einem dritten Ausführungsbeispiel gemäß dem ersten oder zweiten Ausführungsbeispiel ist das erste und zweite elektrische Signal ein Spannungssignal.

Bei einem vierten Ausführungsbeispiel gemäß einem der ersten bis dritten Ausführungsbeispiele gleicht die Anzahl der elektrischen Baudelemente des MSB-Feldes (20, 20'), die auf Basis der MSB-Kombination schaltbar sind, der Anzahl der elektrischen Bauelemente (32a-32c, 32a'-32c') des LSB-Feldes (30, 30'), die auf Basis der LSB-Kombination schaltbar sind.

Bei einem fünften Ausführungsbeispiel gemäß dem vierten Ausführungsbeispiel gleichen die Leitwerte $x_n$ der elektrischen Bauelemente (22a-22c, 22a'-22c') des MSB-Feldes (20, 20') in ihrer Toleranzbehaftung Leitwerten $x_n$ der elektrischen Bauelemente (32a-32c, 32a'-32c') des LSB-Feldes (30, 30').

Bei einem sechsten Ausführungsbeispiel gemäß dem vierten oder fünften Ausführungsbeispiel umfassen das MSB-Feld (20, 20') und das LSB-Feld (30, 30') jeweils mindestens drei elektrische Bauelemente, die auf Basis der MSB-Kombination und/oder auf Basis der LSB-Kombination schaltbar sind.

Bei einem siebten Ausführungsbeispiel gemäß einem der ersten bis sechsten Ausführungsbeispiele gilt für die mathematische Folge $x_n = 2\, x_{n-1}$.

Bei einem achten Ausführungsbeispiel gemäß einem der ersten bis siebten Ausführungsbeispiele ist ein Leitwert des Koppelements als Funktion der Leitwerte der elektrischen Bauelemente (22a-22c, 22a'-22c') des MSB-Feldes (20, 20') und/oder als Funktion der Leitwerte der elektrischen Bauelemente (32a-32c, 32a'-32c') des LSB-Feldes (30, 30') definiert; oder der Leitwert ist durch die Formel

$$x_{koppel} > \frac{\left(\sum_{n=0}^{n=k}(x_n)\right)+1}{\sum_{n=0}^{n=k}(x_n)}$$

definiert.

Bei einem neunten Ausführungsbeispiel gemäß einem der ersten bis achten Ausführungsbeispiele umfasst der Digital-Analog-Wandler (10, 10') ein weiteres LSB-Feld (30, 30') mit einer dritten Mehrzahl der elektrischen Bauelemente (22a-22c, 32a-32c, 22a'-22c', 32a'-32c'), welches über ein weiteres Koppelelement (14, 14') mit dem LSB-Feld (30, 30') und dem MSB-Feld (20, 20') zu einer Parallelschaltung gekoppelt ist.

Bei einem zehnten Ausführungsbeispiel gemäß einem der ersten bis neunten Ausführungsbeispiele weist das elektrische Schaltsignal ($V_{REF+}$, $V_{REF-}$) zum selektiven Aktivieren der elektrischen Bauelemente (22a-22c, 22a'-22c') des MSB-Feldes (20, 20') und zum selektiven Aktivieren der elektrischen Bauelemente (32a-32c, 32a'-32c') des LSB-Feldes (30, 30') eine Referenzspannung ($V_{CM}$, $V_{LSB}$) auf, während das elektrische Schaltsignal ($V_{REF+}$, $V_{REF-}$) zum selektiven Deaktivieren der elektrischen Schaltelemente des MSB-Feldes (20, 20') und zum selektiven Deaktivieren der elektrischen Schaltelemente des LSB-Feldes (30, 30') ein Nullsignal, Massesignal oder eine Referenzspannung $V_{REF-}$ umfasst.

Bei einem elften Ausführungsbeispiel gemäß einem der ersten bis zehnten Ausführungsbeispiele ist die Kalibriereinheit (12) ausgebildet, um beim Variieren der ersten MSB-Kombination (120) die erste MSB-Kombination um eine toleranzbehaftete niedrigste Bitwertigkeit für das MSB-Feld (20, 20') zu variieren.

Bei einem zwölften Ausführungsbeispiel gemäß einem der ersten bis elften Ausführungsbeispiele ist der erste Toleranzwert dem elektrischen Bauelement des MSB-Feldes (20, 20') mit der niedrigsten Bitwertigkeit zugeordnet.

Bei einem dreizehnten Ausführungsbeispiel gemäß einem der ersten bis zwölften Ausführungsbeispiele ist der weitere Toleranzwert der Gruppe von elektrischen Bauelementen (22a-22c, 22a'-22c') des MSB-Feldes (20, 20') zugeordnet, welche zumindest das der niedrigsten Bitwertigkeit zugeordnete elektrische Bauelement und das der nächst höheren Bitwertigkeit zugeordnete elektrische Bauelement umfasst.

Bei einem vierzehnten Ausführungsbeispiel gemäß einem der ersten bis dreizehnten Ausführungsbeispiele ist die Kalibriereinheit (12) ausgebildet, um jedes zu kalibrierende elektrische Bauelement des MSB-Feldes (20, 20') und/oder für jede zu kalibrierende Gruppe von elektrischen Bauelementen (22a-22c, 22a'-22c') des MSB-Feldes (20, 20') eine erste MSB-Kombination vorzugeben.

Bei einem fünfzehnten Ausführungsbeispiel gemäß einem der ersten bis vierzehnten Ausführungsbeispiele ist die Kalibriereinheit (12) ausgebildet, um zum Ermitteln des sich einstellenden ersten elektrischen Signals ausgehend von der ersten MSB-Kombination die erste LSB-Kombination so lange zu variieren, bis die erste MSB-Kombination zusammen mit der ersten LSB-Kombination zu einem ersten elektrischen Signal an dem Summenpunkt (16) führt; und/oder die Kalibriereinheit (12) ist ausgebildet, um zum Ermitteln des sich einstellenden zweiten elektrischen Signals ausgehend von der zweiten MSB-Kombination die zweite LSB-Kombination so lange zu variieren, bis die zweite MSB-Kombination zusammen mit der zweiten LSB-Kombination zu einem zweiten elektrischen Signal an dem Summenpunkt (16) führt.

Bei einem sechzehnten Ausführungsbeispiel gemäß einem der ersten bis fünfzehnten Ausführungsbeispiele ist die Kalibriereinheit (12) ausgebildet, um als erste MSB-Kombination und als erste LSB-Kombination eine Kombination zu nutzen, die von einem an einem Messsignaleingang des Digital-Analog-Wandler (10, 10') anliegenden elektrischen Messsignal ($V_{IN}$) abhängig ist.

Bei einem siebzehnten Ausführungsbeispiel gemäß einem der ersten bis sechzehnten Ausführungsbeispiele umfasst die Kalibriereinheit (12) einen Zwischenspeicher, der abhängig von der jeweiligen MSB-Kombination den ersten Toleranzwert und/oder den weiteren Toleranzwert für mehrere elektrische Bauelemente (22a-22c, 22a'-22c') des MSB-Feldes (20, 20') speichert, so dass auf Basis der Mehrzahl der Toleranzwerte für jedes elektrische Bauelement des MSB-Feldes (20, 20') ein spezifischer Toleranzwert berechenbar ist.

Bei einem achtzehnten Ausführungsbeispiel gemäß einem der ersten bis siebzehnten Ausführungsbeispiele ist die Kalibriereinheit (12) ausgebildet, um auf Basis eines Gleichungssystems, das mindestens so viele Gleichungen wie Toleranzwerte umfasst, spezifische, den elektrischen Bauelementen (22a-22c, 22a'-22c') des MSB-Feldes (20, 20') zugeordneten Toleranzwerte zu berechnen.

Bei einem neunzehnten Ausführungsbeispiel gemäß einem der ersten bis achtzehnten Ausführungsbeispiele ist der erste Toleranzwert und der weitere Toleranzwert ein von einem Leitwert für das Koppelelement (14, 14') abhängiger Wert.

Bei einem zwanzigsten Ausführungsbeispiel gemäß einem der ersten bis neunzehnten Ausführungsbeispiele ist die Kalibriereinheit (12) ausgebildet, um eine Vielzahl an ermittelten und berechneten, den einzelnen elektrischen Bauelementen (22a-22c, 22a'-22c') des MSB-Feldes (20, 20') zugeordneten, selektiven Toleranzwerten zu mitteln, um einen gemittelten selektiven Toleranzwert zu erhalten.

Bei einem einundzwanzigsten Ausführungsbeispiel gemäß einem der ersten bis zwanzigsten Ausführungsbeispiele ist die Kalibriereinheit (12) ausgebildet, um unter Nutzung eines Komparators (42), welcher einen Messsignaleingang umfasst, über den der Komparator (42) mit dem Summenpunkt (16) verbunden ist, das erste und zweite elektrische Signal zu ermitteln.

Bei einem zweiundzwanzigsten Ausführungsbeispiel gemäß dem einundzwanzigsten Ausführungsbeispiel erfolgt das Ermitteln des ersten elektrischen Signals (110) und/oder des zweiten elektrischen Signals durch sukzessive Approximation mittels des LSB-Feldes (30, 30').

Bei einem dreiundzwanzigsten Ausführungsbeispiel gemäß dem ersten Ausführungsbeispiel umfassen die elektrischen Bauelemente (22a-22c, 32a-32c, 22a'-22c', 32a'-32c') des MSB-Feldes (20, 20') und die elektrischen Bauelemente (32a-32c, 32a'-32c') des LSB-Feldes (30, 30') jeweils Widerstände.

Ein vierundzwanzigstes Ausführungsbeispiel schafft eine Analog-Digital-Wandler (40, 40') mit folgenden Merkmalen,

einem Komparator (42); und

einem Digital-Analog-Wandler (10, 10') gemäß einem der einem der ersten bis dreiundzwanzigsten Ausführungsbeispiele, wobei der Digital-Analog-Wandler (10, 10') mit einem Messsignaleingang des Komparators (42) mit dem Summenpunkt (16) verbunden ist, so dass ein sukzessiver Approximations-Analog-Digital-Wandler (40, 40') gebildet wird.

Bei einem fünfundzwanzigsten Ausführungsbeispiel gemäß dem vierundzwanzigsten Ausführungsbeispiel ist die Kalibriereinheit (12) mit dem digitalen Ausgang des Komparators (42) verbunden, um abhängig von dem ausgegebenen digitalen Signal bei der Kalibrierung die elektrischen Bauelemente (32a-32c, 32a'-32c') des LSB-Feldes (30, 30') selektiv zu aktivieren und/oder zu deaktivieren.

Bei einem sechsundzwanzigsten Ausführungsbeispiel gemäß dem vierundzwanzigsten oder fünfundzwanzigsten Ausführungsbeispiel ist der Messsignaleingang des Analog-Digital-Wandlers (40, 40') durch den Digital-Analog-Wandler (10, 10') gebildet, und die elektrischen Bauelemente (22a-22c, 32a-32c, 22a'-22c', 32a'-32c') des MSB-Feldes (20, 20') und des LSB-Feldes (30, 30') sind in schaltbarer Weise auf einer ersten Seite der elektrischen Bauelemente (22a-22c, 32a-32c, 22a'-22c', 32a'-32c') mittels des zu bestimmenden elektrischen Messsignals ($V_{IN}$) beaufschlagbar.

Bei einem siebenundzwanzigsten Ausführungsbeispiel gemäß dem sechsundzwanzigsten Ausführungsbeispiel umfassen die elektrischen Bauelemente (22a-22c, 32a-32c, 22a'-22c', 32a'-32c') des MSB-Feldes (20, 20') und des LSB-Feldes (30, 30') Kapazitäten, so dass durch den Digital-Analog-Wandler (10, 10') eine Abtast-Halte-Schaltungs-Funktionalität realisiert wird.

Bei einem achtundzwanzigsten Ausführungsbeispiel gemäß einem der vierundzwanzigsten bis siebenundzwanzigsten ist der Analog-Digital-Wandler (40, 40') ausgebildet, um als digitalisierten Wert des zu bestimmenden elektrischen Messsignals ($V_{IN}$) eine von der MSB-Kombination und/oder der LSB-Kombination abhängige Kombination auszugeben.

Bei einem neunundzwanzigsten Ausführungsbeispiel gemäß dem achtundzwanzigsten Ausführungsbeispiel umfasst der Analog-Digital-Wandler (40, 40') eine Nachbearbeitungseinheit, die ausgebildet ist, die Kombination auf Basis des ersten Toleranzwertes und/oder auf Basis des weiteren Toleranzwertes und/oder auf Basis von selektiven, den jeweiligen elektrischen Bauelementen (22a-22c, 22a'-22c') des MSB-Feldes (20, 20') zugeordneten Toleranzwerten nachzubearbeiten.

Bei einem dreißigsten Ausführungsbeispiel gemäß einem der sechsundzwanzigsten bis neunundzwanzigsten Ausführungsbeispiel umfasst das MSB-Feld (20, 20') einen Referenzspannungseingang, über welche die elektrischen Bauelemente (22a-22c, 22a'-22c') des MSB-Feldes (20, 20') in schaltbarer Weise mit einer Referenzspannung ($V_{CM}$) beaufschlagbar sind, wobei der Referenzspannungseingang ($V_{CM}$) auf einer zweiten, der ersten Seite gegenüberliegenden Seite der elektrischen Bauelemente (22a-22c, 22a'-22c') des MSB-Feldes (20, 20') angeordnet ist.

Bei einem einunddreißigsten Ausführungsbeispiel gemäß dem dreißigsten Ausführungsbeispiel wird die Referenzspannung ($V_{CM}$) durch eine Spannungsquelle, die auch die Referenzspannung ($V_{CM}$) für den Komparator (42) bildet, bereitgestellt.

Bei einem zweiunddreißigsten Ausführungsbeispiel gemäß einem der sechsundzwanzigsten bis einunddreißigsten Ausführungsbeispiel umfasst das LSB-Feld (30, 30') einen weiteren Referenzspannungseingang ($V_{LSB}$), über welche die elektrischen Bauelemente (32a-32c, 32a'-32c') des LSB-Feldes (30, 30') in schaltbarer Weise mit einer weiteren Referenzspannung ($V_{LSB}$) beaufschlagbar sind, wobei der Referenzspannungseingang auf einer zweiten, der ersten Seite gegenüberliegenden Seite der elektrischen Bauelemente (22a-22c, 32a-32c, 22a'-22c', 32a'-32c') des LSB-Feldes (30, 30') angeordnet ist.

Bei einem dreiunddreißigsten Ausführungsbeispiel gemäß einem der vierundzwanzigsten bis zweiunddreißigsten Ausführungsbeispiele ist die Kalibriereinheit (12) ausgebildet, um die Kalibrierung ausgehend von einer Vielzahl an unterschiedlichen zu ermittelnden, an dem Messsignaleingang anliegenden, elektrischen Messsignalen ($V_{IN}$), denen jeweils eine erste Kombination aus der ersten MSB-Kombination und der ersten LSB-Kombination, und eine zweite Kombination aus der zweiten MSB-Kombination und der zweiten LSB-Kombination zuzuordnen ist, durchzuführen.

Bei einem vierunddreißigsten Ausführungsbeispiel gemäß dem vierundzwanzigsten oder fünfundzwanzigsten Ausführungsbeispiel ist der Messsignaleingang des Analog-Digital-Wandlers (40, 40') durch einen weiteren Messsignaleingang des Komparators (42) gebildet, über welchen das zu bestimmende elektrische Messsignal ($V_{IN}$) dem Analog-Digital-Wandler zuführbar ist.

Bei einem fünfunddreißigsten Ausführungsbeispiel gemäß dem vierunddreißigsten Ausführungsbeispiel umfasst Messsignaleingang des Analog-Digital-Wandlers (40, 40') eine Abtast-Halte-Schaltung.

Ein sechsunddreißigstes Ausführungsbeispiel schafft ein Verfahren (100) zur Kalibrierung eines Digital-Analog-Wandlers (10, 10'), mit folgenden Merkmalen:

einem MSB-Feld (20, 20') mit einer Mehrzahl an elektrischen Bauelementen (22a-22c, 22a'-22c'), die einen gemeinsamen MSB-Summenpunkt (26) bilden und jeweils selektiv entsprechend einer MSB-Kombination mittels eines elektrischen Schaltsignals ($V_{REF+}$, $V_{REF-}$) beaufschlagbar sind, wobei die Mehrzahl der elektrischen Bauelementen (22a-22c, 22a'-22c') unterschiedliche Leitwerte x (R, $C_{EINHEIT}$, $C_0$, $C_1$, $C_2$) aufweisen, die entsprechend einem Ausschnitt einer mathematischen Folge mit $x_n = f(x_{n-1})$ in Relation zueinander stehen und/oder um jeweilige Toleranzwerte von der mathematischen Folge $x_n = f(x_{n-1})$ abweichen;

einem LSB-Feld (30, 30') mit einer zweiten Mehrzahl der elektrischen Bauelemente (32a-32c, 32a'-32c'), die einen gemeinsamen LSB-Summenpunkt (36) bilden und jeweils entsprechend einer LSB-Kombination mittels des elektrischen Schaltsignals ($V_{REF+}$, $V_{REF-}$) beaufschlagbar sind; und

einem Koppelelement (14, 14'), über welches der LSB-Summenpunkt (36) und der MSB-Summenpunkt (26) miteinander gekoppelt sind;

wobei durch die elektrischen Bauelemente (22a-22c, 32a-32c, 22a'-22c', 32a'-32c') des MSB-Feldes (20, 20') und des LSB-Feldes (30, 30') bei Anliegen des elektrischen Schaltsignals ($V_{REF+}$, $V_{REF-}$) ein elektrisches Signal an einem Summenpunkt (16), welcher mit dem MSB-Summenpunkt (26) und dem LSB-Summenpunkt (36) gekoppelt ist, erzeugt wird, wobei das elektrische Signal von der MSB-Kombination und der LSB-Kombination abhängig ist,

wobei das Verfahren (100) folgende Schritte umfasst:

Ermitteln von den jeweiligen Toleranzwerten für die elektrischen Bauelemente (22a-22c, 22a'-22c') des MSB-Feldes (20, 20') mit den Unterschritten:

Ermitteln das erste, sich infolge der ersten MSB-Kombination einstellenden elektrischen Signal (110) an dem Summenpunkt (16) unter Berücksichtigung einer ersten LSB-Kombination;

Variieren der ersten MSB-Kombination (120), um eine zweite MSB-Kombination zu erhalten; und

Ermitteln (130) ausgehend von der zweiten MSB-Kombination einer zweite LSB-Kombination, die zusammen mit der zweiten MSB-Kombination zu einem zweiten elektrischen Signal an dem Summenpunkt (16) führt, das in seiner Toleranzbehaftung dem ersten elektrischen Signal gleicht,

wobei die zweite LSB-Kombination zusammen mit einer ersten LSB-Kombination Auskunft über einen ersten Toleranzwert für ein elektrisches Bauelement des MSB-Feldes (20, 20') oder Auskunft über einen weiteren Toleranzwert für eine Gruppe von elektrischen Bauelementen (22a-22c, 22a'-22c') des MSB-Feldes (20, 20') gibt.

Bei einem siebenunddreißigsten Ausführungsbeispiel gemäß dem sechsunddreißigsten Ausführungsbeispiel umfasst der Schritt des Ermittelns des ersten elektrischen Signals wiederholtes Variieren der ersten LSB-Kombination in Abhängigkeit der ersten MSB-Kombination, wobei die erste LSB-Kombination solange variiert wird bis die erste MSB-Kombination zusammen mit der ersten LSB-Kombination zu einem ersten elektrischen Signal an dem Summenpunkt (16) führt, und wobei der Schritt des Ermittelns des zweiten elektrischen Signals wiederholtes Variieren der zweiten LSB-Kombination in Abhängigkeit der zweiten MSB-Kombination umfasst, wobei die zweite LSB-Kombination solange variiert wird bis die zweite MSB-Kombination zusammen mit der zweiten LSB-Kombination zu einem zweiten elektrischen Signal an dem Summenpunkt (16) führt.

Bei einem achtunddreißigsten Ausführungsbeispiel gemäß dem sechsunddreißigsten oder siebenunddreißigsten Ausführungsbeispiel ist der erste Toleranzwert für das elektrische Bauelement des MSB-Feldes (20, 20') mit der niedrigsten Bitwertigkeit auf Basis einer Differenz zwischen der ersten und zweiten LSB-Kombination ermittelbar, wenn die zur Kalibrierung des elektrischen Bauelements des MSB-Feldes (20, 20') mit der niedrigsten Bitwertigkeit, erste und zweite MSB-Kombination gewählt ist; und/oder

der weitere Toleranzwert für die Gruppe der elektrischen Bauelemente (22a-22c, 22a'-22c') des MSB-Feldes (20, 20') ist auf Basis einer Differenz zwischen der ersten und zweiten LSB-Kombination ermittelbar, wenn die zur Kalibrierung der Gruppe der elektrischen Bauelemente (22a-22c, 22a'-22c') des MSB-Feldes (20, 20'), erste und zweite MSB-Kombination gewählt ist.

Bei einem neununddreißigsten Ausführungsbeispiel gemäß einem der sechsunddreißigsten bis achtunddreißigsten Ausführungsbeispiele wird das Verfahren (100) parallel zu der Ermittlung einer Vielzahl zu ermittelnder Messsignale ($V_{IN}$) durchgeführt.

Bei einem vierzigsten Ausführungsbeispiel gemäß einem der sechsunddreißigsten bis neununddreißigsten Ausführungsbeispiele umfasst das Verfahren (100) den Schritt des Lösens eines Gleichungssystems (140), das mindestens so viele Gleichungen wie Toleranzwerte umfasst, nach dem Schritt des Ermittelns von den jeweiligen Toleranzwerten, um spezifische, den elektrischen Bauelementen (22a-22c, 22a'-22c') des MSB-Feldes (20, 20') zugeordneten Toleranzwerte zu berechnen.

Ein einundvierzigsten Ausführungsbeispiel schafft ein Computerprogramm mit einem Programmcode zur Durchführung des Verfahrens nach einem der der sechsunddreißigsten bis vierzigsten Ausführungsbeispiele, wenn das Programm auf einer CPU abläuft.

Obwohl manche Aspekte im Zusammenhang mit einer Vorrichtung beschrieben wurden, versteht es sich, dass diese Aspekte auch eine Beschreibung des entsprechenden Verfahrens darstellen, sodass ein Block oder ein Bauelement einer Vorrichtung auch als ein entsprechender Verfahrensschritt oder als ein Merkmal eines Verfahrensschrittes zu verstehen ist. Analog dazu stellen Aspekte, die im Zusammenhang mit einem oder als ein Verfahrensschritt beschrieben wurden, auch eine Beschreibung eines entsprechenden Blocks oder Details oder Merkmals einer entsprechenden Vorrichtung dar. Einige oder alle der Verfahrensschritte können durch einen Hardware-Apparat (oder unter Verwendung eines Hardware-Apparats), wie zum Beispiel einen Mikroprozessor, einen programmierbaren Computer oder eine elektronische Schaltung ausgeführt werden. Bei einigen Ausführungsbeispielen können einige oder mehrere der wichtigsten Verfahrensschritte durch einen solchen Apparat ausgeführt werden.

Je nach bestimmten Implementierungsanforderungen können Ausführungsbeispiele der Erfindung in Hardware oder in Software implementiert sein. Die Implementierung kann unter Verwendung eines digitalen Speichermediums, beispielsweise einer Floppy-Disk, einer DVD, einer Blu-ray Disc, einer CD, eines ROM, eines PROM, eines EPROM, eines EEPROM oder eines FLASH-Speichers, einer Festplatte oder eines anderen magnetischen oder optischen Speichers durchgeführt werden, auf dem elektronisch lesbare Steuersignale gespeichert sind, die mit einem programmierbaren Computersystem derart zusammenwirken können oder zusammenwirken, dass das jeweilige Verfahren durchgeführt wird. Deshalb kann das digitale Speichermedium computerlesbar sein.

Manche Ausführungsbeispiele gemäß der Erfindung umfassen also einen Datenträger, der elektronisch lesbare Steuersignale aufweist, die in der Lage sind, mit einem programmierbaren Computersystem derart zusammenzuwirken, dass eines der hierin beschriebenen Verfahren durchgeführt wird.

Allgemein können Ausführungsbeispiele der vorliegenden Erfindung als Computerprogrammprodukt mit einem Programmcode implementiert sein, wobei der Programmcode dahin gehend wirksam ist, eines der Verfahren durchzuführen, wenn das Computerprogrammprodukt auf einem Computer abläuft.

Der Programmcode kann beispielsweise auch auf einem maschinenlesbaren Träger gespeichert sein.

Andere Ausführungsbeispiele umfassen das Computerprogramm zum Durchführen eines der hierin beschriebenen Verfahren, wobei das Computerprogramm auf einem maschinenlesbaren Träger gespeichert ist.

Mit anderen Worten ist ein Ausführungsbeispiel des erfindungsgemäßen Verfahrens somit ein Computerprogramm, das einen Programmcode zum Durchführen eines der hierin beschriebenen Verfahren aufweist, wenn das Computerprogramm auf einem Computer abläuft.

Ein weiteres Ausführungsbeispiel der erfindungsgemäßen Verfahren ist somit ein Datenträger (oder ein digitales Speichermedium oder ein computerlesbares Medium), auf dem das Computerprogramm zum Durchführen eines der hierin beschriebenen Verfahren aufgezeichnet ist.

Ein weiteres Ausführungsbeispiel des erfindungsgemäßen Verfahrens ist somit ein Datenstrom oder eine Sequenz von Signalen, der bzw. die das Computerprogramm zum Durchführen eines der hierin beschriebenen Verfahren darstellt bzw. darstellen. Der Datenstrom oder die Sequenz von Signalen kann bzw. können beispielsweise dahin gehend konfiguriert sein, über eine Datenkommunikationsverbindung, beispielsweise über das Internet, transferiert zu werden.

Ein weiteres Ausführungsbeispiel umfasst eine Verarbeitungseinrichtung, beispielsweise einen Computer oder ein programmierbares Logikbauelement, die dahin gehend konfiguriert oder angepasst ist, eines der hierin beschriebenen Verfahren durchzuführen.

Ein weiteres Ausführungsbeispiel umfasst einen Computer, auf dem das Computerprogramm zum Durchführen eines der hierin beschriebenen Verfahren installiert ist.

Ein weiteres Ausführungsbeispiel gemäß der Erfindung umfasst eine Vorrichtung oder ein System, die bzw. das ausgelegt ist, um ein Computerprogramm zur Durchführung zumindest eines der hierin beschriebenen Verfahren zu einem Empfänger zu übertragen. Die Übertragung kann beispielsweise elektronisch oder optisch erfolgen. Der Empfänger kann beispielsweise ein Computer, ein Mobilgerät, ein Speichergerät oder eine ähnliche Vorrichtung sein. Die Vorrichtung oder das System kann beispielsweise einen Datei-Server zur Übertragung des Computerprogramms zu dem Empfänger umfassen.

Bei manchen Ausführungsbeispielen kann ein programmierbares Logikbauelement (beispielsweise ein feldprogrammierbares Gatterarray, ein FPGA) dazu verwendet werden, manche oder alle Funktionalitäten der hierin beschriebenen Verfahren durchzuführen. Bei manchen Ausführungsbeispielen kann ein feldprogrammierbares Gatterarray mit einem Mikroprozessor zusammenwirken, um eines der hierin beschriebenen Verfahren durchzuführen. Allgemein werden die Verfahren bei einigen Ausführungsbeispielen seitens einer beliebigen Hardwarevorrichtung durchgeführt. Diese kann eine universell einsetzbare Hardware wie ein Computerprozessor (CPU) sein oder für das Verfahren spezifische Hardware, wie beispielsweise ein ASIC.

Die oben beschriebenen Ausführungsbeispiele stellen lediglich eine Veranschaulichung der Prinzipien der vorliegenden Erfindung dar. Es versteht sich, dass Modifikationen und Variationen der hierin beschriebenen Anordnungen und Einzelheiten anderen Fachleuten einleuchten werden. Deshalb ist beabsichtigt, dass die Erfindung lediglich durch den Schutzumfang der nachstehenden Patentansprüche und nicht durch die spezifischen Einzelheiten, die anhand der Beschreibung und der Erläuterung der Ausführungsbeispiele hierin präsentiert wurden, beschränkt sei.

**Patentansprüche**

1. Digital-Analog-Wandler (10, 10'), mit folgenden Merkmalen:

    einem MSB-Feld (20, 20') mit einer Mehrzahl an elektrischen Bauelementen (22a-22c, 22a'-22c'), die einen gemeinsamen MSB-Summenpunkt (26) bilden und jeweils selektiv entsprechend einer MSB-Kombination mittels eines elektrischen Schaltsignals ($V_{REF+}$, $V_{REF-}$) beaufschlagbar sind, wobei die Mehrzahl der elektrischen Bauelementen (22a-22c, 22a'-22c') unterschiedliche Leitwerte x (R, $C_{EINHEIT}$, $C_0$, $C_1$, $C_2$) aufweisen, die entsprechend einem Ausschnitt einer mathematischen Folge mit $x_n = f(x_{n-1})$ in Relation zueinander stehen und/oder um jeweilige Toleranzwerte von der mathematischen Folge $x_n = f(x_{n-1})$ abweichen;
    einem LSB-Feld (30, 30') mit einer zweiten Mehrzahl der elektrischen Bauelemente (32a-32c, 32a'-32c'), die einen gemeinsamen LSB-Summenpunkt (36) bilden und jeweils entsprechend einer LSB-Kombination mittels des elektrischen Schaltsignals ($V_{REF+}$, $V_{REF-}$) beaufschlagbar sind;
    einem Koppelelement (14, 14'), über welches der LSB-Summenpunkt (36) und der MSB-Summenpunkt (26) miteinander gekoppelt sind; und
    einer Kalibriereinheit (12), die ausgebildet ist, um die jeweiligen Toleranzwerte für die elektrischen Bauelemente (22a-22c, 22a'-22c') des MSB-Feldes (20, 20') zu ermitteln,
    wobei durch die elektrischen Bauelemente (22a-22c, 32a-32c, 22a'-22c', 32a'-32c') des MSB-Feldes (20, 20') und des LSB-Feldes (30, 30') bei Anliegen des elektrischen Schaltsignals ($V_{REF+}$, $V_{REF-}$) ein elektrisches Signal an einem Summenpunkt (16), welcher mit dem MSB-Summenpunkt (26) und dem LSB-Summenpunkt (36) gekoppelt ist, erzeugt wird, wobei das elektrische Signal von der MSB-Kombination und der LSB-Kombination abhängig ist,
    wobei die Kalibriereinheit (12) ausgebildet ist, um ein sich infolge einer ersten MSB-Kombination einstellendes, erstes elektrisches Signal an dem Summenpunkt (16) unter Berücksichtigung einer ersten LSB-Kombination zu ermitteln, wobei die Kalibriereinheit (12) ausgebildet ist, um die erste MSB-Kombination zu variieren, um eine zweite MSB-Kombination zu erhalten, und wobei die Kalibriereinheit (12) ausgebildet ist, um ausgehend von der zweiten MSB-Kombination eine zweite LSB-Kombination zu ermitteln, die zusammen mit der zweiten MSB-Kombination zu einem zweiten elektrischen Signal an dem Summenpunkt (16) führt, das in seiner Toleranzbehaftung dem ersten elektrischen Signal gleicht,
    wobei die zweite LSB-Kombination zusammen mit der ersten LSB-Kombination Auskunft über einen ersten Toleranzwert für ein elektrisches Bauelement des MSB-Feldes (20, 20') oder Auskunft über einen weiteren Toleranzwert für eine Gruppe von elektrischen Bauelementen (22a-22c, 22a'-22c') des MSB-Feldes (20, 20') gibt.

2. Digital-Analog-Wandler (10, 10') gemäß Anspruch 1, wobei die elektrischen Bauelemente (22a-22c, 32a-32c, 22a'-22c', 32a'-32c') und das Koppelelement (14, 14') jeweils mindestens eine Kapazität umfassen, oder wobei die elektrischen Bauelemente (22a-22c, 32a-32c, 22a'-22c', 32a'-32c') des MSB-Feldes (20, 20') und die elektrischen Bauelemente (32a-32c, 32a'-32c') des LSB-Feldes (30, 30') jeweils Widerstände umfassen.

3. Digital-Analog-Wandler (10, 10') gemäß Anspruch 1 oder 2, wobei die Anzahl der elektrischen Baudelemente des MSB-Feldes (20, 20'), die auf Basis der MSB-Kombination schaltbar sind, der Anzahl der elektrischen Bauelemente (32a-32c, 32a'-32c') des LSB-Feldes (30, 30'), die auf Basis der LSB-Kombination schaltbar sind, gleicht.

4. Digital-Analog-Wandler (10, 10') gemäß Anspruch 3, wobei die Leitwerte $x_n$ der elektrischen Bauelemente (22a-22c, 22a'-22c') des MSB-Feldes (20, 20') in ihrer Toleranzbehaftung Leitwerten $x_n$ der elektrischen Bauelemente (32a-32c, 32a'-32c') des LSB-Feldes (30, 30') gleichen.

5. Digital-Analog-Wandler (10, 10') gemäß einem der Ansprüche 1 bis 4, wobei ein Leitwert des Koppelements als Funktion der Leitwerte der elektrischen Bauelemente (22a-22c, 22a'-22c') des MSB-Feldes (20, 20') und/oder als Funktion der Leitwerte der elektrischen Bauelemente (32a-32c, 32a'-32c') des LSB-Feldes (30, 30') definiert ist; oder wobei der Leitwert durch die Formel

$$x_{koppel} > \frac{\left(\sum_{n=0}^{n=k}(x_n)\right)+1}{\sum_{n=0}^{n=k}(x_n)}$$

definiert ist.

6. Digital-Analog-Wandler (10, 10') gemäß einem der Ansprüche 1 bis 5, wobei der Digital-Analog-Wandler (10, 10') ein weiteres LSB-Feld (30, 30') mit einer dritten Mehrzahl der elektrischen Bauelemente (22a-22c, 32a-32c, 22a'-22c', 32a'-32c') umfasst, welches über ein weiteres Koppelelement (14, 14') mit dem LSB-Feld (30, 30') und dem MSB-Feld (20, 20') zu einer Parallelschaltung gekoppelt ist.

7. Digital-Analog-Wandler (10, 10') gemäß einem der Ansprüche 1 bis 6, wobei das elektrische Schaltsignal ($V_{REF+}$, $V_{REF-}$) zum selektiven Aktivieren der elektrischen Bauelemente (22a-22c, 22a'-22c') des MSB-Feldes (20, 20') und zum selektiven Aktivieren der elektrischen Bauelemente (32a-32c, 32a'-32c') des LSB-Feldes (30, 30') eine Referenzspannung ($V_{CM}$, $V_{LSB}$) aufweist, während das elektrische Schaltsignal ($V_{REF+}$, $V_{REF-}$) zum selektiven Deaktivieren der elektrischen Schaltelemente des MSB-Feldes (20, 20') und zum selektiven Deaktivieren der elektrischen Schaltelemente des LSB-Feldes (30, 30') ein Nullsignal, Massesignal oder eine Referenzspannung $V_{REF-}$ umfasst.

8. Digital-Analog-Wandler (10, 10') gemäß einem der Ansprüche 1 bis 7, wobei die Kalibriereinheit (12) ausgebildet ist, um
beim Variieren der ersten MSB-Kombination (120) die erste MSB-Kombination um eine toleranzbehaftete niedrigste Bitwertigkeit für das MSB-Feld (20, 20') zu variieren, und/oder
jedes zu kalibrierendes elektrisches Bauelement des MSB-Feldes (20, 20') und/oder für jede zu kalibrierende Gruppe von elektrischen Bauelementen (22a-22c, 22a'-22c') des MSB-Feldes (20, 20') eine erste MSB-Kombination vorzugeben, und/oder
zum Ermitteln des sich einstellenden ersten elektrischen Signals ausgehend von der ersten MSB-Kombination die erste LSB-Kombination so lange zu variieren, bis die erste MSB-Kombination zusammen mit der ersten LSB-Kombination zu einem ersten elektrischen Signal an dem Summenpunkt (16) führt; und/oder wobei die Kalibriereinheit (12) ausgebildet ist, um zum Ermitteln des sich einstellenden zweiten elektrischen Signals ausgehend von der zweiten MSB-Kombination die zweite LSB-Kombination so lange zu variieren, bis die zweite MSB-Kombination zusammen mit der zweiten LSB-Kombination zu einem zweiten elektrischen Signal an dem Summenpunkt (16) führt, und/oder
als erste MSB-Kombination und als erste LSB-Kombination eine Kombination zu nutzen, die von einem an einem Messsignaleingang des Digital-Analog-Wandler (10, 10') anliegenden elektrischen Messsignal ($V_{IN}$) abhängig ist, und/oder
auf Basis eines Gleichungssystems, das mindestens so viele Gleichungen wie Toleranzwerte umfasst, spezifische, den elektrischen Bauelementen (22a-22c, 22a'-22c') des MSB-Feldes (20, 20') zugeordneten Toleranzwerte zu berechnen, und/oder
um eine Vielzahl an ermittelten und berechneten, den einzelnen elektrischen Bauelementen (22a-22c, 22a'-22c') des MSB-Feldes (20, 20') zugeordneten, selektiven Toleranzwerten zu mitteln, um einen gemittelten selektiven Toleranzwert zu erhalten, und/oder
untern Nutzung eines Komparators (42), welcher einen Messsignaleingang umfasst, über den der Komparator (42) mit dem Summenpunkt (16) verbunden ist, das erste und zweite elektrische Signal zu ermitteln.

9. Digital-Analog-Wandler (10, 10') gemäß einem der Ansprüche 1 bis 8, wobei die Kalibriereinheit (12) einen Zwischenspeicher umfasst, der abhängig von der jeweiligen MSB-Kombination den ersten Toleranzwert und/oder den weiteren Toleranzwert für mehrere elektrische Bauelemente (22a-22c, 22a'-22c') des MSB-Feldes (20, 20') speichert, so dass auf Basis der Mehrzahl der Toleranzwerte für jedes elektrische Bauelement des MSB-Feldes (20, 20') ein spezifischer Toleranzwert berechenbar ist.

10. Analog-Digital-Wandler (40, 40') mit folgenden Merkmalen,
einem Komparator (42); und
einem Digital-Analog-Wandler (10, 10') gemäß einem der Ansprüche 1 bis 9, wobei der Digital-Analog-Wandler (10, 10') mit einem Messsignaleingang des Komparators (42) mit dem Summenpunkt (16) verbunden ist, so dass ein sukzessiver Approximations-Analog-Digital-Wandler (40, 40') gebildet wird.

11. Verfahren (100) zur Kalibrierung eines Digital-Analog-Wandlers (10, 10'), mit folgenden Merkmalen:

einem MSB-Feld (20, 20') mit einer Mehrzahl an elektrischen Bauelementen (22a-22c, 22a'-22c'), die einen gemeinsamen MSB-Summenpunkt (26) bilden und jeweils selektiv entsprechend einer MSB-Kombination mittels eines elektrischen Schaltsignals ($V_{REF+}$, $V_{REF-}$) beaufschlagbar sind, wobei die Mehrzahl der elektrischen Bauelementen (22a-22c, 22a'-22c') unterschiedliche Leitwerte x (R, $C_{EINHEIT}$, $C_0$, $C_1$, $C_2$) aufweisen, die entsprechend einem Ausschnitt einer mathematischen Folge mit $x_n = f(x_{n-1})$ in Relation zueinander stehen und/oder um jeweilige Toleranzwerte von der mathematischen Folge $x_n = f(x_{n-1})$ abweichen; einem LSB-Feld (30, 30') mit einer zweiten Mehrzahl der elektrischen Bauelemente (32a-32c, 32a'-32c'), die einen gemeinsamen LSB-Summenpunkt (36) bilden und jeweils entsprechend einer LSB-Kombination mittels des elektrischen Schaltsignals ($V_{REF+}$, $V_{REF-}$) beaufschlagbar sind; und einem Koppelelement (14, 14'), über welches der LSB-Summenpunkt (36) und der MSB-Summenpunkt (26) miteinander gekoppelt sind; wobei durch die elektrischen Bauelemente (22a-22c, 32a-32c, 22a'-22c', 32a'-32c') des MSB-Feldes (20, 20') und des LSB-Feldes (30, 30') bei Anliegen des elektrischen Schaltsignals ($V_{REF+}$, $V_{REF-}$) ein elektrisches Signal an einem Summenpunkt (16), welcher mit dem MSB-Summenpunkt (26) und dem LSB-Summenpunkt (36) gekoppelt ist, erzeugt wird, wobei das elektrische Signal von der MSB-Kombination und der LSB-Kombination abhängig ist,

wobei das Verfahren (100) folgende Schritte umfasst:

Ermitteln von den jeweiligen Toleranzwerten für die elektrischen Bauelemente (22a-22c, 22a'-22c') des MSB-Feldes (20, 20') mit den Unterschritten:

Ermitteln das erste, sich infolge der ersten MSB-Kombination einstellenden elektrisches Signal (110) an dem Summenpunkt (16) unter Berücksichtigung einer ersten LSB-Kombination; Variieren der ersten MSB-Kombination (120), um eine zweite MSB-Kombination zu erhalten; und Ermitteln (130) ausgehend von der zweiten MSB-Kombination einer zweite LSB-Kombination, die zusammen mit der zweiten MSB-Kombination zu einem zweiten elektrischen Signal an dem Summenpunkt (16) führt, das in seiner Toleranzbehaftung dem ersten elektrischen Signal gleicht, wobei die zweite LSB-Kombination zusammen mit einer ersten LSB-Kombination Auskunft über einen ersten Toleranzwert für ein elektrisches Bauelement des MSB-Feldes (20, 20') oder Auskunft über einen weiteren Toleranzwert für eine Gruppe von elektrischen Bauelementen (22a-22c, 22a'-22c') des MSB-Feldes (20, 20') gibt.

12. Verfahren (100) gemäß Anspruch 11, wobei der Schritt des Ermittelns des ersten elektrischen Signals wiederholtes Variieren der ersten LSB-Kombination in Abhängigkeit der ersten MSB-Kombination umfasst, wobei die erste LSB-Kombination solange variiert wird bis die erste MSB-Kombination zusammen mit der ersten LSB-Kombination zu einem ersten elektrischen Signal an dem Summenpunkt (16) führt, und wobei der Schritt des Ermittelns des zweiten elektrischen Signals wiederholtes Variieren der zweiten LSB-Kombination in Abhängigkeit der zweiten MSB-Kombination umfasst, wobei die zweite LSB-Kombination solange variiert wird bis die zweite MSB-Kombination zusammen mit der zweiten LSB-Kombination zu einem zweiten elektrischen Signal an dem Summenpunkt (16) führt.

13. Verfahren (100) gemäß Anspruch 11 oder 12, wobei der erste Toleranzwert für das elektrische Bauelement des MSB-Feldes (20, 20') mit der niedrigsten Bitwertigkeit auf Basis einer Differenz zwischen der ersten und zweiten LSB-Kombination ermittelbar ist, wenn die zur Kalibrierung des elektrischen Bauelements des MSB-Feldes (20, 20') mit der niedrigsten Bitwertigkeit, erste und zweite MSB-Kombination gewählt ist; und/oder wobei der weitere Toleranzwert für die Gruppe der elektrischen Bauelemente (22a-22c, 22a'-22c') des MSB-Feldes (20, 20') auf Basis einer Differenz zwischen der ersten und zweiten LSB-Kombination ermittelbar ist, wenn die zur Kalibrierung der Gruppe der elektrischen Bauelemente (22a-22c, 22a'-22c') des MSB-Feldes (20, 20'), erste und zweite MSB-Kombination gewählt ist.

14. Verfahren (100) gemäß einem der Ansprüche 11 bis 13, wobei das Verfahren (100) den Schritt des Lösens eines Gleichungssystems (140), das mindestens so viele Gleichungen wie Toleranzwerte umfasst, nach dem Schritt des Ermittelns von den jeweiligen Toleranzwerten aufweist; um spezifische, den elektrischen Bauelementen (22a-22c, 22a'-22c') des MSB-Feldes (20, 20') zugeordneten Toleranzwerte zu berechnen.

15. Computerprogramm mit einem Programmcode zur Durchführung des Verfahrens nach einem der Ansprüche 11 bis 14, wenn das Programm auf einer CPU abläuft.

FIGUR 1

FIGUR 2

FIGUR 3A

FIGUR 3B

**Europäisches Patentamt**
**European Patent Office**
**Office européen des brevets**

# EUROPÄISCHER RECHERCHENBERICHT

Nummer der Anmeldung

EP 15 15 1291

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | WO 2012/123578 A1 (ANACATUM DESIGN AB [SE]; JANSSON CHRISTER [SE]) 20. September 2012 (2012-09-20) | 1,3-15 | INV. H03M1/10 |
| Y | * Seite 5, Zeilen 26-29 * <br> * Seite 3, Zeilen 15-16 * <br> * Seite 11, Zeile 22 * <br> * Seite 12, Zeilen 12-14 * <br> * Seite 13, Zeile 10 * <br> * Seite 13, Zeilen 17-19 * <br> * Seite 14, Zeilen 7-9 * <br> * Seite 14, Zeilen 12-19 * <br> * Seite 14, Zeile 22 - Seite 15, Zeile 4 * <br> * Gleichungen 7, 13, 15, 17 und 18 * <br> * Gleichungen 20-21 * <br> * Gleichungen 25-27 * <br> * Abbildungen 1,7-11 * <br> ----- | 2 | ADD. H03M1/06 H03M1/46 H03M1/68 |
| Y | JUNKEI GOTOH ED - INSTITUTE OF ELECTRICAL AND ELECTRONICS ENGINEERS: "A SELF-CALIBRATING 16BIT 6US CMOS AUDIO ADC", PROCEEDINGS OF THE CUSTOM INTEGRATED CIRCUITS CONFERENCE. BOSTON, MAY 13 - 16, 1990; [PROCEEDINGS OF THE CUSTOM INTEGRATED CIRCUITS CONFERENCE], NEW YORK, IEEE, US, Bd. CONF. 12, 13. Mai 1990 (1990-05-13), Seiten 621-624, XP000167808, * Abbildung 1 * <br> ----- <br> -/-- | 2 | |

**RECHERCHIERTE SACHGEBIETE (IPC)**

H03M

Der vorliegende Recherchenbericht wurde für alle Patentansprüche erstellt

| Recherchenort | Abschlußdatum der Recherche | Prüfer |
|---|---|---|
| Den Haag | 12. Juni 2015 | Rocha, Daniel |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument

...........................................................................

& : Mitglied der gleichen Patentfamilie, übereinstimmendes Dokument

EPO FORM 1503 03.82 (P04C03)

**Europäisches Patentamt**
**European Patent Office**
**Office européen des brevets**

# EUROPÄISCHER RECHERCHENBERICHT

Nummer der Anmeldung

EP 15 15 1291

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| Y | MOTOHIRO NAKANO ET AL: "A CONTINUOUSLY CALIBRATING CHARGE REDISTRIBUTION A/D CONVERTER", ELECTRONICS & COMMUNICATIONS IN JAPAN, PART II - ELECTRONICS, WILEY, HOBOKEN, NJ, US, Bd. 72, Nr. 12, Dezember 1989 (1989-12), Seiten 96-104, XP000136858, ISSN: 8756-663X * Abbildungen 2,3 * ----- | 2 | |
| A | US 2007/075884 A1 (MELANSON JOHN L [US] ET AL) 5. April 2007 (2007-04-05) * das ganze Dokument * ----- | 1-15 | |
| | | | **RECHERCHIERTE SACHGEBIETE (IPC)** |

Der vorliegende Recherchenbericht wurde für alle Patentansprüche erstellt

| Recherchenort | Abschlußdatum der Recherche | Prüfer |
|---|---|---|
| Den Haag | 12. Juni 2015 | Rocha, Daniel |

EPO FORM 1503 03.82 (P04C03)

**ANHANG ZUM EUROPÄISCHEN RECHERCHENBERICHT
ÜBER DIE EUROPÄISCHE PATENTANMELDUNG NR.**

EP 15 15 1291

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

12-06-2015

| Im Recherchenbericht angeführtes Patentdokument | Datum der Veröffentlichung | Mitglied(er) der Patentfamilie | | Datum der Veröffentlichung |
|---|---|---|---|---|
| WO 2012123578 A1 | 20-09-2012 | CN | 103444083 A | 11-12-2013 |
| | | EP | 2686960 A1 | 22-01-2014 |
| | | JP | 2014512111 A | 19-05-2014 |
| | | KR | 20140031869 A | 13-03-2014 |
| | | TW | 201246799 A | 16-11-2012 |
| | | US | 2014070970 A1 | 13-03-2014 |
| | | WO | 2012123578 A1 | 20-09-2012 |
| US 2007075884 A1 | 05-04-2007 | US | 2007075884 A1 | 05-04-2007 |
| | | WO | 2007041378 A1 | 12-04-2007 |

EPO FORM P0461

Für nähere Einzelheiten zu diesem Anhang : siehe Amtsblatt des Europäischen Patentamts, Nr.12/82

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 4970514 A